# EUROPEAN PATENT APPLICATION

(11) **EP 4 793 744 A1**
(43) Date of publication of application: **19.08.2026**
(21) Application number: 26158270.4
(22) Date of filing: 12.02.2026
(51) Int. Cl.: G06F 3/041, G06F 3/044

(54) **ELECTRONIC DEVICE**

(30) Priority: 18.02.2025 KR 20250020998
(71) Applicant: Samsung Display Co., Ltd., Yongin-si, Gyeonggi-do (KR)
(72) Inventor: JEONG, Hwan-Hee, Yongin-si (KR); BANG, Gyeongnam, Yongin-si (KR)
(74) Representative: Marks & Clerk LLP

(57) **Abstract**

An electronic device includes: a display layer to display an image; and a sensor layer on the display layer, and to sense an external input. The sensor layer includes: a plurality of first electrodes along a first direction; a plurality of second electrodes along a second direction crossing the first direction; a plurality of third electrodes along the first direction; a loop trace line including: a first line portion extending in the first direction; and a protruding portion protruding and extending from the first line portion toward the plurality of third electrodes, and electrically connected to the plurality of third electrodes; and a shield line between the protruding portion and the display layer.

## Description

### BACKGROUND

Aspects of embodiments of the present disclosure relate to an electronic device having improved performance.

Multimedia electronic devices, such as a TV, a mobile phone, a tablet personal computer (PC), a laptop computer, a navigation system, a game console, and the like, includes a display device that displays an image. In addition to a general input method, such as a button, a keyboard, a mouse, or the like, the electronic devices may include a sensor layer (e.g., an input sensor) capable of providing a touch-based input method that allows a user to enter information or commands more easily and intuitively. The sensor layer may sense a user's touch or pressure. As such, there is an increasing demand for employing a pen for a finer touch input for a user who is accustomed to entering information by using writing instruments, or for a specific application (e.g. an application for sketching or drawing).

The above information disclosed in this Background section is for enhancement of understanding of the background of the present disclosure, and therefore, it may contain information that does not constitute prior art.

### SUMMARY

Embodiments of the present disclosure may be directed to an electronic device having improved performance.

According to one or more embodiments of the present disclosure, an electronic device includes: a display layer configured to display an image; and a sensor layer on the display layer, and configured to sense an external input. The sensor layer includes: a plurality of first electrodes along a first direction; a plurality of second electrodes along a second direction crossing the first direction; a plurality of third electrodes along the first direction; a loop trace line including: a first line portion extending in the first direction; and a protruding portion protruding and extending from the first line portion toward the plurality of third electrodes, and electrically connected to the plurality of third electrodes; and a shield line between the protruding portion and the display layer.

In an embodiment, the shield line may include: a shield line portion spaced from the plurality of third electrodes; and a shield protruding portion protruding and extending from the shield line portion, and overlapping with the protruding portion. The first line portion may be located between the shield line portion and the plurality of third electrodes.

In an embodiment, a width of the shield protruding portion in the first direction may be greater than a width of the protruding portion in the first direction.

In an embodiment, the shield line portion may include: a first shield line layer; and a second shield line layer on the first shield line layer, and connected to the first shield line layer through a contact. The contact may have a line shape extending along the first direction.

In an embodiment, the shield protruding portion may protrude and extend from the first shield line layer.

In an embodiment, the first line portion may include: a first line layer at a same layer as that of the first shield line layer; and a second line layer at a same layer as that of the second shield line layer, and connected to the first line layer through a contact. The protruding portion may protrude and extend from the second line layer.

In an embodiment, the shield line may be located between the first line portion and the plurality of third electrodes.

In an embodiment, the sensor layer may further include: a plurality of first trace lines electrically connected to the plurality of first electrodes in a one-to-one correspondence; and a plurality of second trace lines electrically connected to the plurality of second electrodes in a one-to-one correspondence. The loop trace line may further include: a second line portion extending from an end of the first line portion in the second direction; and a third line portion extending from an opposite end of the first line portion in the second direction. Some of the plurality of second trace lines may be located between the second line portion and the plurality of first electrodes, and others of the plurality of second trace lines may be located between the third line portion and the plurality of first electrodes.

In an embodiment, the shield line may include: a first shield line portion extending in the first direction, and overlapping with the protruding portion; and a second shield line portion extending from an end of the first shield line portion in the second direction. At least some of the plurality of second trace lines may overlap with the second shield line portion.

In an embodiment, the third line portion may not overlap with the second shield line portion.

In an embodiment, the display layer may include: a light emitting element including a pixel electrode, an emission layer on the pixel electrode, and a common electrode on the emission layer. The shield line may be located between an end of the common electrode and the protruding portion.

In an embodiment, the electronic device may further include a ground pad connected to the shield line.

In an embodiment, the shield line may be configured to receive a constant voltage.

According to one or more embodiments of the present disclosure, an electronic device includes: a sensor layer including a sensing area, and a peripheral area adjacent to the sensing area; and a processor configured to control an operation of the sensor layer. The sensor layer includes: a plurality of first electrodes in the sensing area, and spaced from each other along a first direction; a plurality of second electrodes in the sensing area, and spaced from each other along a second direction crossing the first direction; a plurality of third electrodes in the sensing area along the first direction; a loop trace line including: a first line portion in the peripheral area, and extending in the first direction; and a plurality of protruding portions protruding and extending from the first line portion toward the plurality of third electrodes; and a shield line in the peripheral area, and overlapping with the plurality of protruding portions.

In an embodiment, the sensor layer may include: a plurality of first trace lines electrically connected to the plurality of first electrodes in a one-to-one correspondence; a plurality of second trace lines electrically connected to the plurality of second electrodes in a one-to-one correspondence; and a plurality of pads electrically connected to the plurality of first trace lines and the plurality of second trace lines, and located in the peripheral area. The sensing area may be located between the first line portion and the plurality of pads.

In an embodiment, the shield line may include: a first shield line portion extending in the first direction, and overlapping with the plurality of protruding portions; and a second shield line portion extending from an end of the first shield line portion in the second direction. At least some of the plurality of second trace lines may overlap with the second shield line portion.

In an embodiment, the shield line may include: a shield line portion spaced from the sensing area; and a plurality of shield protruding portions protruding and extending from the shield line portion, and overlapping with the plurality of protruding portions. The first line portion may be located between the shield line and the sensing area.

In an embodiment, a width of each of the plurality of shield protruding portions in the first direction may be greater than a width of each of the plurality of protruding portions in the first direction.

In an embodiment, the shield line may be located between the first line portion and the sensing area, and the plurality of protruding portions may overlap with the shield line.

In an embodiment, the shield line may be grounded, or may be configured to receive a constant voltage.

However, the present disclosure is not limited to the above aspects and features, and the above and additional aspects and features will be set forth, in part, in the detailed description that follows with reference to the drawings, and in part, may be apparent therefrom, or may be learned by practicing one or more of the presented embodiments of the present disclosure.

At least some of the above and other features of the invention are set out in the claims.

### BRIEF DESCRIPTION OF THE DRAWINGS

The above and other aspects and features of the present disclosure will be more clearly understood from the following detailed description of the illustrative, nonlimiting embodiments with reference to the accompanying drawings.
FIG. 1 is a block diagram of an electronic device according to an embodiment of the present disclosure.
FIG. 2A is a front perspective view of an electronic device according to an embodiment of the present disclosure.
FIG. 2B is a rear perspective view of an electronic device according to an embodiment of the present disclosure.
FIG. 3 is a perspective view of an electronic device according to an embodiment of the present disclosure.
FIG. 4 is a perspective view of an electronic device according to an embodiment of the present disclosure.
FIG. 5 is a schematic cross-sectional view of a display panel according to an embodiment of the present disclosure.
FIG. 6 is a block diagram illustrating an operation of an electronic device according to an embodiment of the present disclosure.
FIG. 7A is a cross-sectional view of a display panel according to an embodiment of the present disclosure.
FIG. 7B is a cross-sectional view illustrating some components of a sensor layer according to an embodiment of the present disclosure.
FIG. 8 is a plan view of a sensor layer according to an embodiment of the present disclosure.
FIG. 9A is a plan view illustrating a first conductive layer of a sensing unit according to an embodiment of the present disclosure.
FIG. 9B is a plan view illustrating a second conductive layer of a sensing unit according to an embodiment of the present disclosure.
FIG. 10 is an enlarged plan view of the area AA' illustrated in FIG. 9B.
FIG. 11 is a plan view illustrating some components of a display layer and some components of a sensor layer according to an embodiment of the present disclosure.
FIG. 12 is an enlarged plan view of the area BB' illustrated in FIG. 11.
FIG. 13 is a cross-sectional view taken along the line I-I' illustrated in FIG. 12 according to an embodiment of the present disclosure.
FIG. 14 is a plan view of a sensor layer according to an embodiment of the present disclosure.
FIG. 15A is an enlarged plan view of the area CC' illustrated in FIG. 14.
FIG. 15B is an enlarged plan view of the area CC' illustrated in FIG. 14.
FIG. 16 is a cross-sectional view taken along the line II-II' illustrated in FIG. 15A or the line II-II' illustrated in FIG. 15B according to an embodiment of the present disclosure.
FIG. 17 is a cross-sectional view taken along the line III-III' illustrated in FIG. 14 according to an embodiment of the present disclosure.
FIG. 18 is a schematic cross-sectional view of a display layer and a sensor layer according to an embodiment of the present disclosure.
FIG. 19 is a schematic cross-sectional view of a display layer and a sensor layer according to an embodiment of the present disclosure.
FIG. 20 is a schematic cross-sectional view of a display layer and a sensor layer according to an embodiment of the present disclosure.
FIG. 21 is a block diagram illustrating an operation of a sensor driver according to an embodiment of the present disclosure.
FIG. 22 illustrates an operation of a sensor driver according to an embodiment of the present disclosure.
FIG. 23 is a schematic view illustrating a first mode according to an embodiment of the present disclosure.
FIG. 24 is a schematic view illustrating a second mode according to an embodiment of the present disclosure.
FIG. 25A is a graph illustrating a waveform of a first signal according to an embodiment of the present disclosure.
FIG. 25B is a graph illustrating a waveform of a second signal according to an embodiment of the present disclosure.
FIG. 26A is a schematic view illustrating a second mode according to an embodiment of the present disclosure.
FIG. 26B is a schematic view illustrating a second mode based on one sensing unit according to an embodiment of the present disclosure.

### DETAILED DESCRIPTION

Hereinafter, embodiments will be described in more detail with reference to the accompanying drawings, in which like reference numbers refer to like elements throughout. The present disclosure, however, may be embodied in various different forms, and should not be construed as being limited to only the illustrated embodiments herein. Rather, these embodiments are provided as examples so that this disclosure will be thorough and complete, and will fully convey the aspects and features of the present disclosure to those skilled in the art. Accordingly, processes, elements, and techniques that are not necessary to those having ordinary skill in the art for a complete understanding of the aspects and features of the present disclosure may not be described. Unless otherwise noted, like reference numerals denote like elements throughout the attached drawings and the written description, and thus, redundant description thereof may not be repeated.

When a certain embodiment may be implemented differently, a specific process order may be different from the described order. For example, two consecutively described processes may be performed at the same or substantially at the same time, or may be performed in an order opposite to the described order.

Further, as would be understood by a person having ordinary skill in the art, in view of the present disclosure in its entirety, each suitable feature of the various embodiments of the present disclosure may be combined or combined with each other, partially or entirely, and may be technically interlocked and operated in various suitable ways, and each embodiment may be implemented independently of each other or in conjunction with each other in any suitable manner, unless otherwise stated or implied.

In the drawings, the relative sizes, thicknesses, and ratios of elements, layers, and regions may be exaggerated and/or simplified for clarity. Spatially relative terms, such as "beneath," "below," "lower," "under," "above," "upper," and the like, may be used herein for ease of explanation to describe one element or feature's relationship to another element(s) or feature(s) as illustrated in the figures. It will be understood that the spatially relative terms are intended to encompass different orientations of the device in use or in operation, in addition to the orientation depicted in the figures. For example, if the device in the figures is turned over, elements described as "below" or "beneath" or "under" other elements or features would then be oriented "above" the other elements or features. Thus, the example terms "below" and "under" can encompass both an orientation of above and below. The device may be otherwise oriented (e.g., rotated 90 degrees or at other orientations) and the spatially relative descriptors used herein should be interpreted accordingly.

Further, it should be expected that the shapes shown in the figures may vary in practice depending, for example, on tolerances and/or manufacturing techniques. Accordingly, the embodiments of the present disclosure should not be construed as being limited to the specific shapes shown in the figures, and should be construed considering changes in shapes that may occur, for example, as a result of manufacturing. As such, the shapes shown in the drawings may not depict the actual shapes of areas of the device, and the present disclosure is not limited thereto.

In the figures, the x-axis, the y-axis, and the z-axis are not limited to three axes of the rectangular coordinate system, and may be interpreted in a broader sense. For example, the x-axis, the y-axis, and the z-axis may be perpendicular to or substantially perpendicular to one another, or may represent different directions from each other that are not perpendicular to one another.

It will be understood that, although the terms "first," "second," "third," etc., may be used herein to describe various elements, components, regions, layers and/or sections, these elements, components, regions, layers and/or sections should not be limited by these terms. These terms are used to distinguish one element, component, region, layer or section from another element, component, region, layer or section. Thus, a first element, component, region, layer or section described below could be termed a second element, component, region, layer or section, without departing from the scope of the present disclosure.

It will be understood that when an element or layer is referred to as being "on," "connected to," or "coupled to" another element or layer, it can be directly on, connected to, or coupled to the other element or layer, or one or more intervening elements or layers may be present. Similarly, when a layer, an area, or an element is referred to as being "electrically connected" to another layer, area, or element, it may be directly electrically connected to the other layer, area, or element, and/or may be indirectly electrically connected with one or more intervening layers, areas, or elements therebetween. In addition, it will also be understood that when an element or layer is referred to as being "between" two elements or layers, it can be the only element or layer between the two elements or layers, or one or more intervening elements or layers may also be present.

The terminology used herein is for the purpose of describing particular embodiments and is not intended to be limiting of the present disclosure. As used herein, the singular forms "a" and "an" are intended to include the plural forms as well, unless the context clearly indicates otherwise. It will be further understood that the terms "comprises," "comprising," "includes," "including," "has," "have," and "having," when used in this specification, specify the presence of the stated features, integers, steps, operations, elements, and/or components, but do not preclude the presence or addition of one or more other features, integers, steps, operations, elements, components, and/or groups thereof. As used herein, the term "and/or" includes any and all combinations of one or more of the associated listed items. For example, the expression "A and/or B" denotes A, B, or A and B. Expressions such as "at least one of," when preceding a list of elements, modify the entire list of elements and do not modify the individual elements of the list. For example, the expression "at least one of a, b, or c," "at least one of a, b, and c," and "at least one selected from the group consisting of a, b, and c" indicates only a, only b, only c, both a and b, both a and c, both b and c, all of a, b, and c, or variations thereof.

As used herein, the term "substantially," "about," and similar terms are used as terms of approximation and not as terms of degree, and are intended to account for the inherent variations in measured or calculated values that would be recognized by those of ordinary skill in the art. Further, the use of "may" when describing embodiments of the present disclosure refers to "one or more embodiments of the present disclosure." As used herein, the terms "use," "using," and "used" may be considered synonymous with the terms "utilize," "utilizing," and "utilized," respectively.

The electronic or electric devices and/or any other relevant devices or components according to embodiments of the present disclosure described herein may be implemented utilizing any suitable hardware, firmware (e.g. an application-specific integrated circuit), software, or a combination of software, firmware, and hardware. For example, the various components of these devices may be formed on one integrated circuit (IC) chip or on separate IC chips. Further, the various components of these devices may be implemented on a flexible printed circuit film, a tape carrier package (TCP), a printed circuit board (PCB), or formed on one substrate. Further, the various components of these devices may be a process or thread, running on one or more processors, in one or more computing devices, executing computer program instructions and interacting with other system components for performing the various functionalities described herein. The computer program instructions are stored in a memory which may be implemented in a computing device using a standard memory device, such as, for example, a random access memory (RAM). The computer program instructions may also be stored in other non-transitory computer readable media such as, for example, a CD-ROM, flash drive, or the like. Also, a person of skill in the art should recognize that the functionality of various computing devices may be combined or integrated into a single computing device, or the functionality of a particular computing device may be distributed across one or more other computing devices without departing from the scope of the example embodiments of the present disclosure.

Unless otherwise defined, all terms (including technical and scientific terms) used herein have the same meaning as commonly understood by one of ordinary skill in the art to which the present disclosure belongs. It will be further understood that terms, such as those defined in commonly used dictionaries, should be interpreted as having a meaning that is consistent with their meaning in the context of the relevant art and/or the present specification, and should not be interpreted in an idealized or overly formal sense, unless expressly so defined herein.

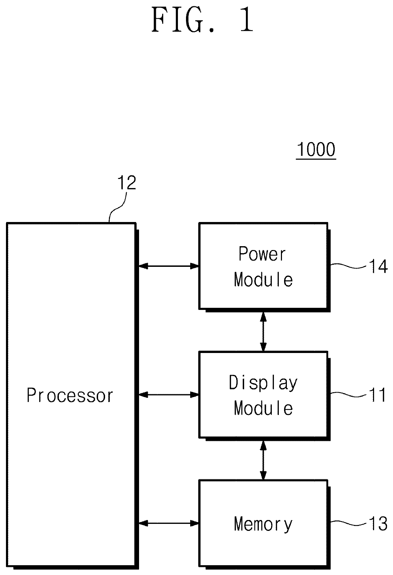

FIG. 1 is a block diagram of an electronic device 1000 according to an embodiment of the present disclosure.

Referring to FIG. 1, the electronic device 1000 according to an embodiment may include a display module (e.g., a display or a touch-display) 11, a processor 12, a memory 13, and a power module (e.g., a power supply circuit or a power supply) 14.

The display module 11 may display an image. The image may include a still image as well as a moving image. The processor 12 may include at least one of a central processing unit (CPU), an application processor (AP), a graphic processing unit (GPU), a communication processor (CP), an image signal processor (ISP), and/or a controller. The processor 12 may control an operation of the display module 11.

Data information used for an operation of the processor 12 or the display module 11 may be stored in the memory 13. When the processor 12 executes an application stored in the memory 13, an image data signal and/or an input control signal may be transmitted to the display module 11, and the display module 11 may process the provided signal to output image information through a display screen.

The power module 14 may include a power supply module, such as a power adapter or a battery device, and a power conversion module that converts an electric power supplied by the power supply module to generate electric power that is used for an operation of the electronic device 1000.

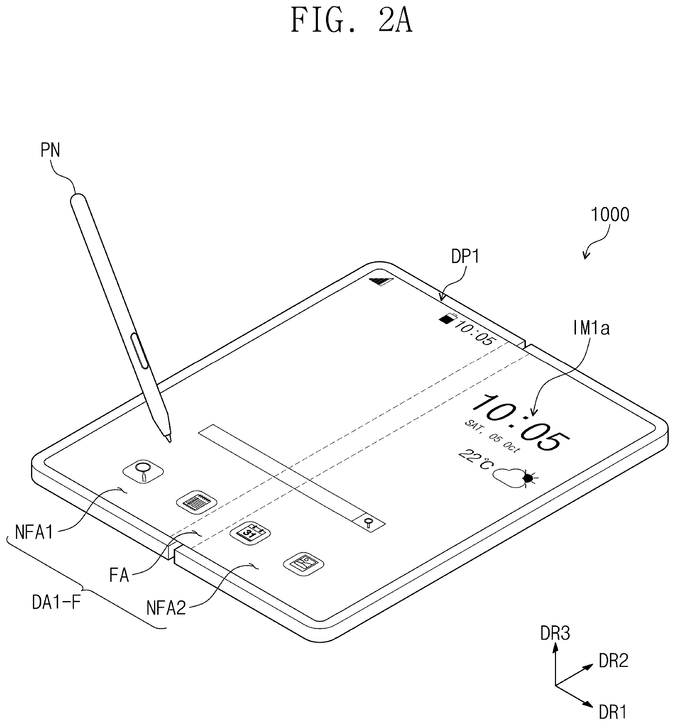

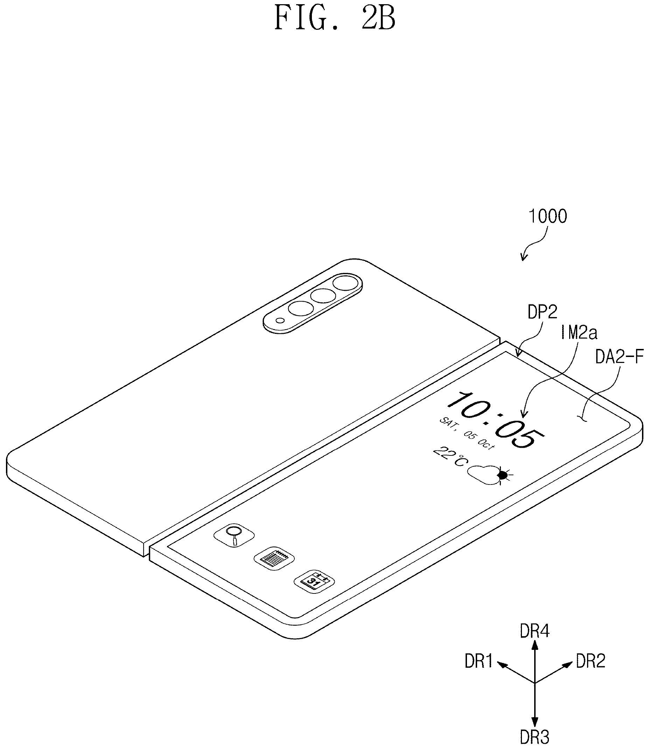

FIG. 2A is a front perspective view of an electronic device 1000 according to an embodiment of the present disclosure. FIG. 2B is a rear perspective view of the electronic device 1000 according to an embodiment of the present disclosure.

Referring to FIGS. 2A and 2B, the electronic device 1000 may be a device that is activated depending on an electrical signal. For example, the electronic device 1000 may display an image, and may sense external inputs applied from the outside. The external input may be a user input. The user input may include various suitable kinds of external inputs, such as a part of the body of a user, a pen PN, light, heat, or pressure.

The electronic device 1000 may include a first display panel DP1 and a second display panel DP2. The first display panel DP1 and the second display panel DP2 may be panels that are separate from each other. The first display panel DP1 may be referred to as a main display panel, and the second display panel DP2 may be referred to as an auxiliary display panel or an external display panel.

The first display panel DP1 may include a first display part DA1-F, and the second display panel DP2 may include a second display part DA2-F. An extent of the second display panel DP2 may be smaller than an extent of the first display panel DP1. The extent of the first display part DA1-F may be greater than the extent of the second display part DA2-F to correspond to the sizes of the first display panel DP1 and the second display panel DP2.

While the electronic device 1000 is unfolded, the first display part DA1-F may have a plane that is parallel to or substantially parallel to a first direction DR1 and a second direction DR2. A thickness direction of the electronic device 1000 may be parallel to or substantially parallel to a third direction DR3 that crosses the first direction DR1 and the second direction DR2. Accordingly, front surfaces (e.g., upper surfaces) and rear surfaces (e.g., lower surfaces) of members that constitute the electronic device 1000 may be defined with respect to the third direction DR3.

The first display panel DP1 or the first display part DA1-F may include a folding area FA that may be folded and unfolded, and a plurality of non-folding areas NFA1 and NFA2 that are spaced from each other with the folding area FA interposed therebetween. The second display panel DP2 may overlap with one of the plurality of non-folding areas NFA1 and NFA2. For example, the second display panel DP2 may overlap with the first non-folding area NFA1.

A display direction of a first image IM1a that is displayed in the first display panel DP1 and a display direction of a second image IM2a that is displayed in the second display panel DP2 may be opposite to each other. For example, the first image IM1a may be displayed in the third direction DR3, and the second image IM2a may be displayed in a fourth direction DR4 that is an opposite direction to the third direction DR3.

In an embodiment of the present disclosure, the folding area FA may be bent with respect to a folding axis that extends in a direction that is parallel to or substantially parallel to long sides of the electronic device 1000, for example, such as a direction that is parallel to or substantially parallel to the second direction DR2. While the electronic device 1000 is folded, the folding area FA has a desired curvature (e.g., a specific or predetermined curvature) and a desired radius of curvature (e.g., a specific or predetermined radius of curvature). The electronic device 1000 may be in-folded, and the first non-folding area NFA1 and the second non-folding area NFA2 may face each other, such that the first display part DA1-F is not exposed to the outside.

In an embodiment of the present disclosure, the electronic device 1000 may be out-folded, such that the first display part DA1-F is exposed to the outside. In an embodiment of the present disclosure, the electronic device 1000 may be both in-folded and out-folded from an unfolded state, but the present disclosure is not limited thereto.

FIG. 2A illustrates that one folding area FA is defined (e.g., provided or included) in the electronic device 1000, but the present disclosure is not limited thereto. For example, a plurality of folding axes and a plurality of folding areas corresponding thereto may be defined in the electronic device 1000, and the electronic device 1000 may be in-folded or out-folded from an unfolded state in each of the plurality of folding areas.

According to an embodiment of the present disclosure, at least one of the first display panel DP1 and/or the second display panel DP2 may sense an input by a pen PN, even though it may not include a digitizer. Accordingly, because the digitizer for sensing the pen PN may be omitted, an increase in the thickness of the electronic device 1000, an increase in the weight of the electronic device 1000, and/or a decrease in a flexibility of the electronic device 1000 may not occur due to an addition of a digitizer. Accordingly, not only the first display panel DP1, but also the second display panel DP2, may be designed to sense the pen PN.

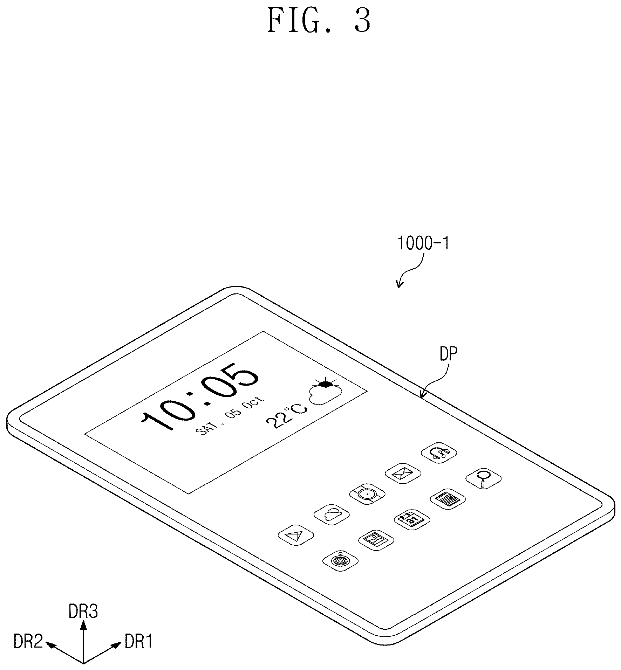

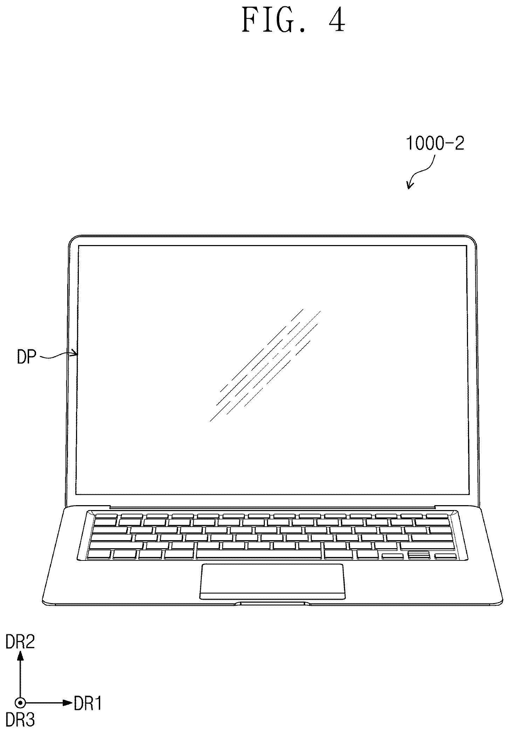

FIG. 3 is a perspective view of an electronic device 1000-1 according to an embodiment of the present disclosure. FIG. 4 is a perspective view of an electronic device 1000-2 according to an embodiment of the present disclosure.

FIG. 3 illustrates that the electronic device 1000-1 is a bar kind of mobile phone, and the electronic device 1000-1 may include a display panel DP. FIG. 4 illustrates that the electronic device 1000-2 is a laptop computer PC, and the electronic device 1000-2 may include a display panel DP. FIG. 4 is a perspective view of the electronic device 1000-2, but the coordinate axes included in FIG. 4 are illustrated with respect to the display panel DP in the electronic device 1000-2.

In an embodiment of the present disclosure, the display panel DP may sense external inputs applied from the outside. The external input may be a user input. The user input may include various suitable kinds of external inputs, such as a part of the body of a user, a pen PN (e.g., see FIG. 2A), light, heat, or pressure.

According to an embodiment of the present disclosure, the display panel DP may sense an input by the pen PN even though the display panel DP does not include a digitizer. Accordingly, because the digitizer for sensing the pen PN may be omitted, the thickness and the weight of the electronic device 1000-1 or 1000-2 may not be increased due to an addition of a digitizer.

FIG. 2A illustrates a foldable kind of the electronic device 1000, by way of an example, and FIG. 3 illustrates a bar kind of the electronic device 1000-1, by way of an example, but the present disclosure is not limited thereto. For example, some embodiments described in more detail below may be applied to various suitable kinds of electronic devices, such as a rollable electronic device, a slidable electronic device, and a stretchable electronic device.

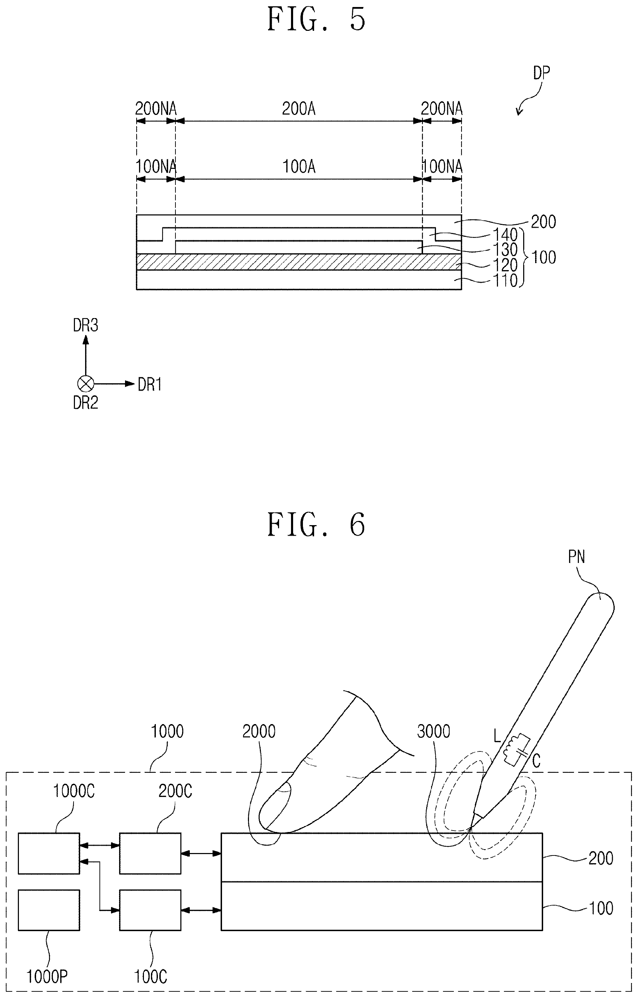

FIG. 5 is a schematic cross-sectional view of a display panel DP according to an embodiment of the present disclosure.

Referring to FIG. 5, the display panel DP may include a display layer 100 and a sensor layer 200. An upper functional member may be further disposed on the sensor layer 200. For example, the upper functional member may include at least one of a reflection prevention layer, a window, and/or a protective film.

The display layer 100 may be a component that generates or substantially generates an image. A display area 100A and a non-display area 100NA adjacent to the display area 100A may be defined in the display layer 100. An image may be displayed in the display area 100A.

The display layer 100 may be a light emitting display layer. For example, the display layer 100 may be an organic light emitting display layer, an inorganic light emitting display layer, an organic-inorganic light emitting display layer, a quantum dot display layer, a micro-LED display layer, or a nano-LED display layer. The display layer 100 may include a base layer 110, a circuit layer 120, a light emitting element layer 130, and an encapsulation layer 140.

The base layer 110 may be a member that provides a base surface on which the circuit layer 120 is disposed. The base layer 110 may include a multi-layered structure or a single layer structure. The base layer 110 may be a glass substrate, a metal substrate, a silicon substrate, or a polymer substrate, but the present disclosure is not particularly limited thereto.

The circuit layer 120 may be disposed on the base layer 110. The circuit layer 120 may include an insulating layer, a semiconductor pattern, a conductive pattern, and a signal line. The insulating layer, the semiconductor layer, and the conductive layer may be formed on the base layer 110 through coating, evaporation, or the like, and the insulating layer, the semiconductor layer, and the conductive layer may be selectively patterned through a plurality of photolithography processes.

The light emitting element layer 130 may be disposed on the circuit layer 120. The light emitting element layer 130 may include a light emitting element. For example, the light emitting element layer 130 may include an organic light emitting material, an inorganic light emitting material, an organic-inorganic light emitting material, a quantum dot, a quantum rod, a micro-LED, or a nano-LED.

The encapsulation layer 140 may be disposed on the light emitting element layer 130. The encapsulation layer 140 may protect the light emitting element layer 130 from moisture, oxygen, and foreign substances, such as dust particles.

The sensor layer 200 may be disposed on the display layer 100. A sensing area 200A and a peripheral area 200NA adjacent to the sensing area 200A may be defined in the sensor layer 200. The sensing area 200A may overlap with the display area 100A, and the peripheral area 200NA may overlap with the non-display area 100NA.

According to an embodiment of the present disclosure, an extent of the sensing area 200A may be (e.g., may correspond to) an extent of the display area 100A or more. FIG. 5 illustrates an example in which the extent of the sensing area 200A and the extent of the display area 100A are the same or substantially the same as each other, but the present disclosure is not limited thereto. For example, a portion of the sensing area 200A may overlap with the non-display area 100NA, and the extent of the sensing area 200A may be greater than the extent of the display area 100A. In this case, even when an input occurs adjacently to a boundary between the display area 100A and the non-display area 100NA, a signal may be sufficiently recognized, because the sensing area 200A also overlaps with a portion of the non-display area 100NA. Accordingly, a coordinate accuracy of a touch that is input to an outskirt of the display area 100A may be further improved.

The sensor layer 200 may sense an external input that is applied from the outside. The sensor layer 200 may be an integrated sensor that is formed continuously during a manufacturing process of the display layer 100, or may be an external sensor that is attached to the display layer 100. The sensor layer 200 may be referred to as a sensor, an input sensing layer, an input sensing panel, or an electronic device for sensing input coordinates.

According to an embodiment of the present disclosure, the sensor layer 200 may sense both inputs by a passive kind of input means, such as the user's body, and an input by an input device that generates a magnetic field of a suitable resonant frequency (e.g., a specific or predetermined resonant frequency). The input device may be referred to as a pen, an input pen, a magnetic pen, a stylus pen, or an electromagnetic resonance pen.

FIG. 6 is a block diagram illustrating an operation of the electronic device 1000 according to an embodiment of the present disclosure.

Referring to FIG. 6, the electronic device 1000 may include a display layer 100, a sensor layer 200, a display driver 100C, a sensor driver 200C, a main driver 1000C, and a power circuit 1000P.

The sensor layer 200 may sense a first input 2000 or a second input 3000 that is applied from the outside. Each of the first input 2000 and the second input 3000 may be an input by an input means capable of providing a change in a capacitance of the sensor layer 200, or an input by an input means capable of causing an induced current in the sensor layer 200. For example, the first input 2000 may be an input by a passive kind of input means, such as a user's body. The second input 3000 may be an input by a pen PN or an input by an RFIC tag. For example, the pen PN may be a passive kind of pen or an active kind of pen.

In an embodiment of the present disclosure, the pen PN may be a device that generates a magnetic field of a suitable resonant frequency (e.g., a specific or predetermined resonant frequency). The pen PN may transmit an output signal based on an electromagnetic resonance method. The pen PN may be referred to as an input device, an input pen, a magnetic pen, a stylus pen, or an electromagnetic resonance pen.

The pen PN may include an RLC resonant circuit, and the RLC resonant circuit may include an inductor L and a capacitor C. In an embodiment of the present disclosure, the RLC resonant circuit may be a variable resonant circuit that changes a resonance frequency. In this case, the inductor L may be a variable inductor and/or the capacitor C may be a variable capacitor, but the present disclosure is not particularly limited thereto.

The inductor L generates a current by a magnetic field that is formed in the electronic device 1000, for example, such as in the sensor layer 200. However, the present disclosure is not particularly limited thereto. For example, when the pen PN is operated in an active kind, the pen PN may generate a current even when the pen PN does not receive a magnetic field from the outside. The generated current is delivered to the capacitor C. The capacitor C is charged by the current that is input from the inductor L, and discharges the charged current to the inductor L. Thereafter, the inductor L may emit a magnetic field of a resonant frequency. An induced current may flow through the sensor layer 200 by the magnetic field emitted by the pen PN, and the induced current may be transmitted to the sensor driver 200C as a reception signal (e.g., a sensing signal).

The main driver 1000C may control the overall operations of the electronic device 1000. For example, the main driver 1000C may control the operations of the display driver 100C and the sensor driver 200C. In other words, the main driver 1000C may control the operations of the display layer 100 and the sensor layer 200. The main driver 1000C may include at least one microprocessor, and may further include a graphics controller. The main driver 1000C may be referred to as an application processor, a central processing unit, or a main processor. The main driver 1000C may correspond to the processor 12 illustrated in FIG. 1.

The display driver 100C may drive the display layer 100. The display driver 100C may receive image data and a control signal from the main driver 1000C. The control signal may include various suitable signals. For example, the control signal may include an input vertical synchronization signal, an input horizontal synchronization signal, a main clock signal, and a data enable signal.

The sensor driver 200C may drive the sensor layer 200. The sensor driver 200C may receive a control signal from the main driver 1000C. The control signal may include a clock signal of the sensor driver 200C. The control signal may further include a mode determination signal that determines operation modes of the sensor driver 200C and the sensor layer 200.

The sensor driver 200C may be implemented as an integrated circuit (IC), and may be electrically connected to the sensor layer 200. For example, the sensor driver 200C may be mounted directly in a specific area of the display panel, or may be mounted on a separate printed circuit board in a chip-on-film (COF) method to be electrically connected to the sensor layer 200.

The sensor driver 200C and the sensor layer 200 may be selectively operated in a first mode or a second mode. For example, the first mode may be a mode in which a touch input, for example, such as the first input 2000, is sensed. The second mode may be a mode in which an input of the pen PN, for example, such as the second input 3000, is sensed. The first mode may be referred to as a touch sensing mode, and the second mode may be referred to as a pen sensing mode.

Switching between the first mode and the second mode may be accomplished in various suitable manners. For example, the sensor driver 200C and the sensor layer 200 may be driven in a time-division method in the first mode and the second mode, and may sense the first input 2000 and the second input 3000. As another example, the switching between the first mode and the second mode may be made due to a user's selection or the user's specific action (or input), any one of the first mode and/or the second mode may be activated or deactivated by activating or deactivating a specific application, or one mode may be switched to the other mode. As another example, while being alternately operated in the first mode and the second mode, the sensor driver 200C and the sensor layer 200 may be maintained in the first mode when the first input 2000 is sensed, or may be maintained in the second mode when the second input 3000 is sensed.

The sensor driver 200C may calculate coordinate information of an input based on a signal that is received from the sensor layer 200, and may provide the main driver 1000C with a coordinate signal having the coordinate information. The main driver 1000C executes an operation corresponding to a user input based on the coordinate signal. For example, the main driver 1000C may operate the display driver 100C, such that a new application image is displayed on the display layer 100.

The power circuit 1000P may include a power management integrated circuit (PMIC). The power circuit 1000P may generate a plurality of driving voltages for driving the display layer 100, the sensor layer 200, the display driver 100C, and the sensor driver 200C. For example, the plurality of driving voltages may include a gate high voltage, a gate low voltage, a first driving voltage, a second driving voltage, an initialization voltage, and/or the like, but the present disclosure is not particularly limited thereto.

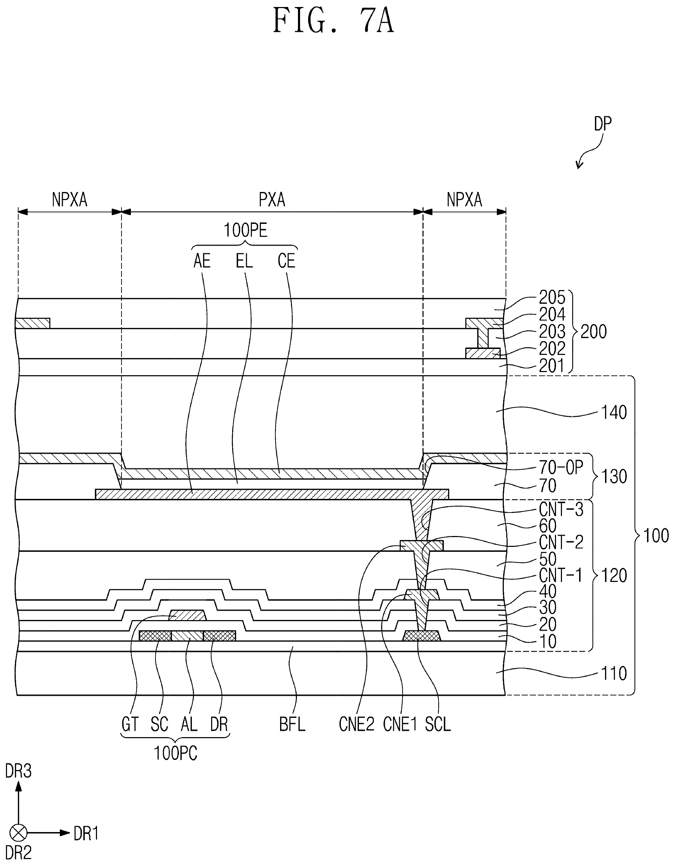

FIG. 7A is a cross-sectional view of the display panel DP according to an embodiment of the present disclosure.

Referring to FIG. 7A, at least one buffer layer BFL may be formed on an upper surface of the base layer 110. The buffer layer BFL may improve a bonding force between the base layer 110 and a semiconductor pattern. The buffer layer BFL may be formed of multi-layers. As another example, the display layer 100 may further include a barrier layer. The buffer layer BFL may include at least one of silicon oxide, silicon nitride, and/or silicon oxynitride. For example, the buffer layer BFL may include a structure in which silicon oxide layers and silicon nitride layers are alternately laminated.

The semiconductor patterns SC, AL, DR, and SCL may be disposed on the buffer layer BFL. The semiconductor patterns SC, AL, DR, and SCL may include polysilicon. However, the present disclosure is not limited thereto, and the semiconductor patterns SC, AL, DR, and SCL may include amorphous silicon, a low-temperature polycrystalline silicon, or an oxide semiconductor.

FIG. 7A illustrates some of the semiconductor patterns SC, AL, DR, and SCL, and another semiconductor pattern may be further disposed in another area. The semiconductor patterns SC, AL, DR, and SCL may be arranged over the pixels in a desired rule (e.g., a specific or predetermined rule). The semiconductor patterns SC, AL, DR, and SCL may have different electrical properties depending on whether or not they are doped. The semiconductor patterns SC, AL, DR, and SCL may include first areas SC, DR, and SCL having a higher conductivity, and a second area AL having a lower conductivity. The first areas SC, DR, and SCL may be doped with an N-type dopant or a P-type dopant. A P-type transistor may include an area doped with the P-type dopant, and an N-type transistor may include an area doped with the N-type dopant. The second area AL may be a non-doped area, or an area that is doped at a concentration lower than those of the first area SC, DR, and SCL.

A conductivity of the first areas SC, DR, and SCL is greater than a conductivity of the second area AL, and the first areas SC, DR, and SCL may serve or substantially serve as an electrode or a signal line. The second area AL may correspond to or substantially correspond to the active area AL (e.g., a channel) of a transistor 100PC. In other words, a portion AL of the semiconductor patterns SC, AL, DR, and SCL may be the active area AL of the transistor 100PC, other portions SC and DR may be a source area SC or a drain area DR of the transistor 100PC, and another portion SCL may be a connection electrode or a connection signal line SCL.

Each of the pixels may be expressed by an equivalent circuit including a plurality of transistors, at least one capacitor, and at least one light emitting element, but the equivalent circuit of the pixel may be variously modified as needed or desired. FIG. 7A illustrates one transistor 100PC and one light emitting element 100PE included in a pixel, by way of an example.

The source area SC, the active area AL, and the drain area DR of the transistor 100PC may be formed from the semiconductor patterns SC, AL, DR, and SCL. The source area SC and the drain area DR may extend in opposite directions as each other from the active area AL on a cross section (e.g., in a cross-sectional view). FIG. 7A illustrates a portion of the connection signal line SCL formed from the semiconductor patterns SC, AL, DR, and SCL. In another view, the connection signal line SCL may be connected to the drain area DR of the transistor 100PC on a plane (e.g., in a plan view).

A first insulating layer 10 may be disposed on the buffer layer BFL. The first insulating layer 10 may overlap with a plurality of pixels in common, and may cover the semiconductor patterns SC, AL, DR, and SCL. The first insulating layer 10 may be an inorganic layer and/or an organic layer, and may have a single layer or multi-layered structure. The first insulating layer 10 may include at least one of aluminum oxide, titanium oxide, silicon oxide, silicon nitride, silicon oxynitride, zirconium oxide, and/or hafnium oxide. In an embodiment, the first insulating layer 10 may be a single layer silicon oxide layer. Not only the first insulating layer 10, but also an insulating layer of the circuit layer 120 other than the first insulating layer 10 described in more detail below, may be an inorganic layer and/or an organic layer, and may have a single layer or multi-layered structure. The inorganic layer may include at least one of the above-described materials, but the present disclosure is not limited thereto.

A gate GT of the transistor 100PC is disposed on the first insulating layer 10. The gate GT may be a portion of a metal pattern. The gate GT overlaps with the active area AL. The gate GT may function as a mask in a process of doping or reducing the semiconductor patterns SC, AL, DR, and SCL.

A second insulating layer 20 is disposed on the first insulating layer 10, and may cover the gate GT. The second insulating layer 20 may overlap with the pixels in common. The second insulating layer 20 may be an inorganic layer and/or an organic layer, and may have a single layer or multi-layered structure. The second insulating layer 20 may include at least one of silicon oxide, silicon nitride, and/or silicon oxynitride. In an embodiment, the second insulating layer 20 may have a multi-layered structure including a silicon oxide layer and a silicon nitride layer.

A third insulating layer 30 may be disposed on the second insulating layer 20. The third insulating layer 30 may have a single layer or multi-layered structure. For example, the third insulating layer 30 may have a multi-layered structure including a silicon oxide layer and a silicon nitride layer.

A first connection electrode CNE1 may be disposed on the third insulating layer 30. The first connection electrode CNE1 may be connected to the connection signal line SCL through a contact hole CNT-1 that passes through the first, second, and third insulating layers 10, 20, and 30.

A fourth insulating layer 40 may be disposed on the third insulating layer 30. The fourth insulating layer 40 may be a single layer silicon oxide layer. A fifth insulating layer 50 may be disposed on the fourth insulating layer 40. The fifth insulating layer 50 may be an organic layer.

A second connection electrode CNE2 may be disposed on the fifth insulating layer 50. The second connection electrode CNE2 may be connected to the first connection electrode CNE1 through a contact hole CNT-2 that passes through the fourth insulating layer 40 and the fifth insulating layer 50.

A sixth insulating layer 60 may be disposed on the fifth insulating layer 50, and may cover the second connection electrode CNE2. The sixth insulating layer 60 may be an organic layer.

The light emitting element layer 130 may be disposed on the circuit layer 120. The light emitting element layer 130 may include a light emitting element 100PE. For example, the light emitting element layer 130 may include an organic light emitting material, an inorganic light emitting material, an organic-inorganic light emitting material, a quantum dot, a quantum rod, a micro-LED, or a nano-LED. Hereinafter, for convenience of illustration, the light emitting element 100PE may be described in more detail in the context of an organic light emitting element, but the present disclosure is not particularly limited thereto.

The light emitting element 100PE may include a first electrode AE, an emission layer EL, and a second electrode CE. The light emitting element 100PE may be disposed in the display area 100A (e.g., see FIG. 5). The first electrode AE may be referred to as a pixel electrode, and the second electrode CE may be referred to as a common electrode.

The first electrode AE may be disposed on the sixth insulating layer 60. The first electrode AE may be connected to the second connection electrode CNE2 through a contact hole CNT-3 that passes through the sixth insulating layer 60.

The pixel definition film 70 may be disposed on the sixth insulating layer 60, and may cover a portion of the first electrode AE. An opening 70-OP is defined in the pixel definition film 70. The opening 70-OP of the pixel definition film 70 exposes at least a portion of the first electrode AE.

The display area 100A (e.g., see FIG. 5) may include an emission area PXA, and a non-emission area NPXA that is adjacent to the emission area PXA. The non-emission area NPXA may surround (e.g., around a periphery of) the emission area PXA. In an embodiment, the emission area PXA is defined as corresponding to a partial area of the first electrode AE, which is exposed by the opening 70-OP.

The emission layer EL may be disposed on the first electrode AE. The emission layer EL may be disposed in an area corresponding to the opening 70-OP. FIG. 7A illustrates an example in which the emission layer EL is disposed in the opening 70-OP, but the present disclosure is not particularly limited thereto. For example, the emission layer EL may extend to cover a side surface of the pixel definition film 70 defining the opening 70-OP, and a portion of an upper surface of the pixel definition film 70.

In an embodiment of the present disclosure, the emission layer EL may be separately included in each of the pixels. When the emission layers EL are separately formed in the pixels, each of the emission layers EL may emit light of at least one of a blue color, a red color, and/or a green color. However, the present disclosure is not limited thereto. For example, the emission layer EL may have an integral shape, and may be included in the plurality of pixels in common. In this case, the emission layer EL may provide blue light or white light.

The second electrode CE may be disposed on the emission layer EL. The second electrode CE may have an integral shape, and may be included in the plurality of pixels in common.

In an embodiment of the present disclosure, a hole control layer may be interposed between the first electrode AE and the emission layer EL. The hole control layer may be disposed in common in the emission area PXA and the non-emission area NPXA. The hole control layer may include a hole transport layer, and may further include a hole injection layer. An electron control layer may be interposed between the emission layer EL and the second electrode CE. The electron control layer may include an electron transport layer, and may further include an electron injection layer. The hole control layer and the electron control layer may be formed in common in the plurality of pixels by using an open mask or an inkjet process.

The encapsulation layer 140 may be disposed on the light emitting element layer 130. The encapsulation layer 140 may include an inorganic layer, an organic layer, and an inorganic layer that are sequentially laminated, but the layers that constitute the encapsulation layer 140 are not limited thereto. The inorganic layers may protect the light emitting element layer 130 from moisture and oxygen, and the organic layer may protect the light emitting element layer 130 from foreign materials, such as dust particles. The inorganic layers may include a silicon nitride layer, a silicon oxynitride layer, a silicon oxide layer, a titanium oxide layer, an aluminum oxide layer, or the like. The organic layer may include an acrylic-based organic layer, but is not limited thereto.

The sensor layer 200 may include a base layer 201, a first conductive layer 202, an intermediate insulating layer 203, a second conductive layer 204, and a cover insulating layer 205.

The base layer 201 may be an inorganic layer including at least one of silicon nitride, silicon oxynitride, and/or silicon oxide. As another example, the base layer 201 may be an organic layer including an epoxy-based resin, an acrylate-based resin, or an imide-based resin. The base layer 201 may have a single layer structure, or may have a multi-layered structure that is laminated in the third direction DR3. In an embodiment of the present disclosure, the sensor layer 200 may not include the base layer 201.

Each of the first conductive layer 202 and the second conductive layer 204 may have a single layer structure, or may have a multi-layered structure in which a plurality of layers are laminated in the third direction DR3.

Each of the first conductive layer 202 and the second conductive layer 204 of the single layer structure may include a metal layer or a transparent conductive layer. The metal layer may include molybdenum, silver, titanium, copper, aluminum, or a suitable alloy thereof. The transparent conductive layer may include a transparent conductive oxide, such as indium tin oxide (ITO), indium zinc oxide (IZO), zinc oxide (ZnO), indium zinc tin oxide (IZTO), or the like. In addition, the transparent conductive layer may include a conductive polymer, such as poly(3,4-ethylenedioxythiophene) (PEDOT), a metal nano wire, graphene, and/or the like.

Each of the first conductive layer 202 and the second conductive layer 204 of the multi-layered structure may include a plurality of metal layers. For example, the metal layers may have a three-layered structure of titanium/aluminum/titanium. The conductive layer of the multi-layered structure may include at least one metal layer and at least one transparent conductive layer.

In an embodiment of the present disclosure, a thickness of the first conductive layer 202 may be greater than or equal to a thickness of the second conductive layer 204. When the thickness of the first conductive layer 202 is greater than the thickness of the second conductive layer 204, a resistance of a component (e.g., an electrode, a pattern, or a bridge pattern) included in the first conductive layer 202 may be reduced. Furthermore, because the first conductive layer 202 is disposed under the second conductive layer 204, a probability that components included in the first conductive layer 202 are visually recognized by an external light reflection may be lower than that of the second conductive layer 204, even though the thickness of the first conductive layer 202 is increased.

At least one of the intermediate insulating layer 203 and/or the cover insulating layer 205 may include an inorganic film. The inorganic film may include at least one of aluminum oxide, titanium oxide, silicon oxide, silicon nitride, silicon oxynitride, zirconium oxide, and/or hafnium oxide.

At least one of the intermediate insulating layer 203 and/or the cover insulating layer 205 may include an organic film. The organic film may include at least one of an acrylate-based resin, a methacrylate-based resin, polyisoprene, a vinyl-based resin, an epoxy-based resin, a urethane-based resin, a cellulose-based resin, a siloxane-based resin, a polyimide-based resin, a polyamide-based resin, and/or a perylene-based resin.

While the sensor layer 200 is described above as including a total of two conductive layers, or in other words, the first conductive layer 202 and the second conductive layer 204, the present disclosure is not particularly limited thereto. For example, the sensor layer 200 may include three or more conductive layers.

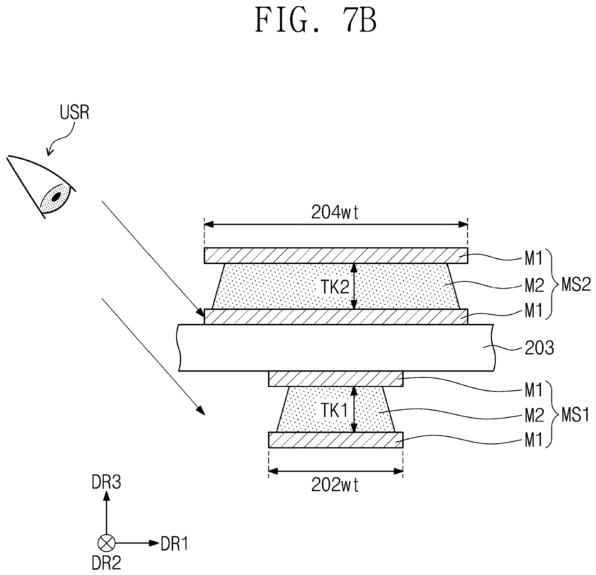

FIG. 7B is a cross-sectional view illustrating some components of the sensor layer 200 according to an embodiment of the present disclosure.

Referring to FIGS. 7A and 7B, a second width 204wt of a second mesh line MS2 included in the second conductive layer 204 may be greater than or equal to a first width 202wt of a first mesh line MS1 included in the first conductive layer 202. When a user USR views the first mesh line MS1 and the second mesh line MS2 from a lateral side, the first mesh line MS1 has the first width 202wt smaller width than the second width 204wt of the second mesh line MS2, and thus, a probability in which the first mesh line MS1 may be visually recognized by the user USR may be reduced.

Each of the first mesh line MS1 and the second mesh line MS2 may include first metal layers M1, and a second metal layer M2 that is disposed between the first metal layers M1. As an example, the first metal layers M1 may include titanium (Ti), and the second metal layer M2 may include aluminum (Al). However, the present disclosure is not particularly limited thereto.

In an embodiment of the present disclosure, a first thickness TK1 of the second metal layer M2 of the first mesh line MS1 and a second thickness TK2 of the second metal layer M2 of the second mesh line MS2 may be the same or substantially the same as each other, but the present disclosure is not particularly limited thereto. For example, the first thickness TK1 may be larger than the second thickness TK2. As another example, the second thickness TK2 may be larger than the first thickness TK1. In an embodiment of the present disclosure, each of the first thickness TK1 and the second thickness TK2 may be 1000 Angstrom or more, for example, such as 6000 Angstrom.

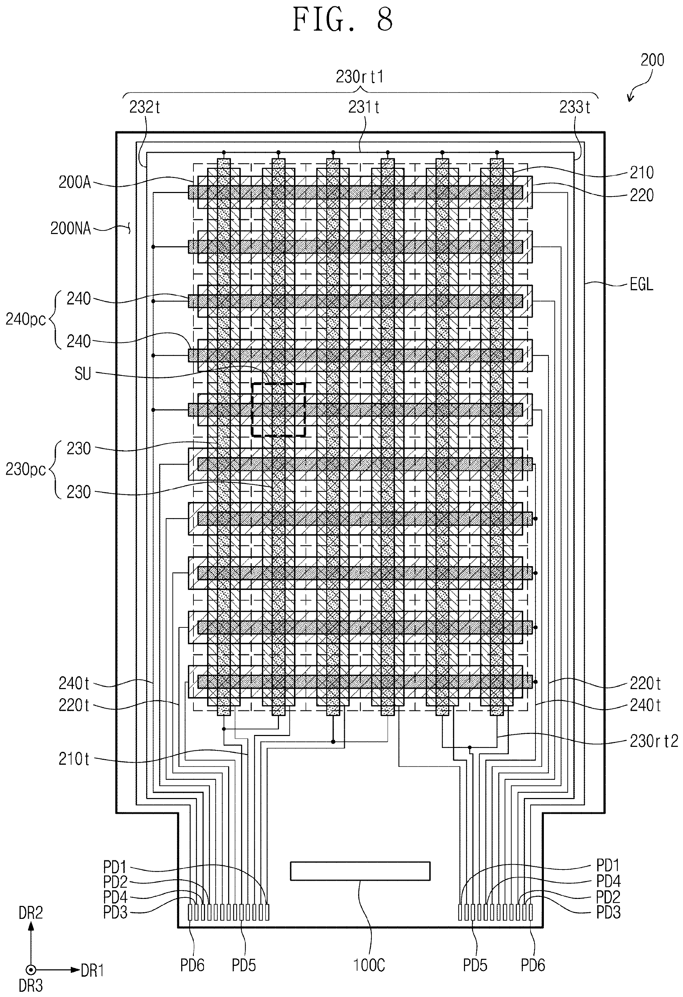

FIG. 8 is a plan view of the sensor layer 200 according to an embodiment of the present disclosure.

Referring to FIG. 8, a sensing area 200A and a peripheral area 200NA adjacent to the sensing area 200A may be defined in the sensor layer 200.

The sensor layer 200 may include a plurality of first electrodes 210, a plurality of second electrodes 220, a plurality of third electrodes 230, and a plurality of fourth electrodes 240, which are disposed in the sensing area 200A.

The first electrodes 210 may cross the second electrodes 220. Each of the first electrodes 210 may extend in the second direction DR2, and the first electrodes 210 may be arranged to be spaced from each other along the first direction DR1. Each of the second electrodes 220 may extend in the first direction DR1, and the second electrodes 220 may be arranged to be spaced from each other along the second direction DR2. A sensing unit (e.g., a sensing region) SU of the sensor layer 200 may be an area in which one first electrode 210 and one second electrode 220 cross each other.

FIG. 8 illustrates six first electrodes 210 and ten second electrodes 220, by way of an example, and thus, illustrates 60 sensing units SU, by way of an example, but the number of the first electrodes 210 and the number of the second electrodes 220 are not limited thereto.

Each of the third electrodes 230 may extend in the second direction DR2, and the third electrodes 230 may be arranged to be spaced from each other along the first direction DR1. One third electrode 230 may at least partially overlap with one first electrode 210. According to an embodiment of the present disclosure, a capacitance (e.g., a coupling capacitance) between one first electrode 210 and one third electrode 230 may be adjusted by adjusting an overlapping extent of one first electrode 210 and one third electrode 230.

In an embodiment of the present disclosure, at least some of the third electrodes 230 may be connected to each other in parallel. For example, FIG. 8 illustrates an example in which two third electrodes 230 are connected to each other in parallel constitute a first electrode group 230pc, and three first electrode groups 230pc may be arranged along the first direction DR1. However, the number of the third electrodes 230 that constitute one first electrode group 230pc is not limited thereto. For example, one first electrode group 230pc may include only one third electrode 230, or may include three or more third electrodes 230.

As the number of the third electrodes 230 that are included in the first electrode group 230pc and are connected to each other in parallel increases, a resistance of the first electrode group 230pc may be lowered, and thus, a power efficiency may be improved and a sensing sensitivity may be improved. On the other hand, as the number of third electrodes 230 that are included in the first electrode group 230pc decreases, a loop coil pattern formed by using the first electrode group 230pc may be implemented in more various forms.

The fourth electrodes 240 may be arranged along the second direction DR2, and the fourth electrodes 240 may extend in the first direction DR1. One fourth electrode 240 may at least partially overlap with one second electrode 220. According to an embodiment of the present disclosure, a capacitance (e.g., a coupling capacitance) between one second electrode 220 and one fourth electrode 240 may be adjusted by adjusting an overlapping extent of one second electrode 220 and one fourth electrode 240.

In an embodiment of the present disclosure, at least some of the fourth electrodes 240 may be electrically connected to each other to constitute one second electrode group 240pc. For example, FIG. 8 illustrates that five fourth electrodes 240 are connected to the same trace line as each other, for example, such as an auxiliary trace line 240t, to form the one second electrode group 240pc. Accordingly, FIG. 8 illustrates that two second electrode groups 240pc are arranged along the second direction DR2. However, the number of fourth electrodes 240 that constitute one second electrode group 240pc is not limited thereto. For example, the number of fourth electrodes 240 that constitute one second electrode group 240pc may be ten, and in this case, the sensor layer 200 may include only one second electrode group 240pc.

The sensor layer 200 may further include a plurality of first trace lines 210t disposed in a peripheral area 200NA, a plurality of first pads PD1 connected to the first trace lines 210t in a one-to-one correspondence, a plurality of second trace lines 220t, and a plurality of second pads PD2 connected to the second trace lines 220t in a one-to-one correspondence. The first trace lines 210t may be electrically connected to the first electrodes 210 in a one-to-one correspondence. The second trace lines 220t may be electrically connected to the second electrodes 220 in a one-to-one correspondence.

The sensor layer 200 may include a first loop trace line 230rt1 that is disposed in the peripheral area 200NA, a plurality of third pads PD3 connected to one end and an opposite end of the first loop trace line 230rt1, auxiliary trace lines 240t, fourth pads PD4 electrically connected to the auxiliary trace lines 240t in a one-to-one correspondence, second loop trace lines 230rt2, and a fifth pad PD5 connected to the second loop trace lines 230rt2 in a one-to-one correspondence. The first loop trace line 230rt1 may be referred to as loop trace lines, the second loop trace lines 230rt2 may be referred to as third trace lines, and the auxiliary trace lines 240t may be referred to as fourth trace lines.

In an embodiment of the present disclosure, the first loop trace line 230rt1 may be electrically connected to the third electrodes 230. In other words, the first loop trace line 230rt1 may be electrically connected to all of the third electrodes 230. The third electrodes 230 may be referred to as charging electrodes.

The first loop trace line 230rt1 may include a first line portion 231t that extends along the first direction DR1 and is electrically connected to the third electrodes 230, a second line portion 232t that extends from a first end of the first line portion 231t along the second direction DR2, and a third line portion 233t that extends from a second end of the first line portion 231t along the second direction DR2.

The first line portion 231t may be spaced apart from the first to fifth pads PD1, PD2, PD3, PD4, and PD5 that are disposed in the peripheral area 200NA with the sensing area 200A interposed therebetween. Some of the second trace lines 220t may be disposed between the second line portion 232t and the first electrodes 210, and others of the second trace lines 220t may be disposed between the third line portion 233t and the first electrodes 210.

Each of the second line portion 232t and the third line portion 233t may extend in the same direction as an extension direction of the third electrodes 230, for example, in the second direction DR2. Each of the second line portion 232t and the third line portion 233t may serve as the first electrode group 230pc, and may obtain the same effect as that of the third electrodes 230 also being disposed in the peripheral area 200NA. For example, any one of the second line portion 232t and/or the third line portion 233t and any one of the third electrodes 230 may form a coil. Accordingly, a pen that is located in an area adjacent to the peripheral area 200NA may also be sufficiently charged by a loop (or a current path) including the second line portion 232t or the third line portion 233t.

In an embodiment of the present disclosure, to adjust a resistance of the second line portion 232t and a resistance of the third line portion 233t, a position and a width of each of the second line portion 232t and the third line portion 233t in the first direction DR1 may be adjusted. In this case, the pen may be sufficiently charged through a current path including the second line portion 232t or the third line portion 233t. As a result, a pen charging performance of the electronic device 1000 (e.g., see FIG. 2A) may be improved. In other words, as a charging rate of the pen is improved, a signal-to-noise ratio of a signal that is provided from the pen may increase. Accordingly, a linearity and an accuracy with respect to a pen input may be improved.

The second loop trace lines 230rt2 may be connected to the first electrode groups 230pc in a one-to-one correspondence. In other words, the number of the second loop trace lines 230rt2 may correspond to the number of the first electrode groups 230pc. FIG. 8 illustrates three second loop trace lines 230rt2 and three first electrode groups 230pc, by way of an example.

The auxiliary trace lines 240t may be spaced from each other with the sensing area 200A interposed therebetween. The auxiliary trace lines 240t may be electrically connected to the second electrode groups 240pc in a one-to-one correspondence. FIG. 8 illustrates that two second electrode groups 240pc are arranged as an example. The auxiliary trace line 240t connected to one second electrode group 240pc, and the auxiliary trace line 240t connected to another second electrode group 240pc may be spaced from each other with the sensing area 200A therebetween. However, the present disclosure is not particularly limited thereto. The auxiliary trace lines 240t may be referred to as trace lines.

In an embodiment, the sensor layer 200 may further include a shield line EGL that is disposed in the peripheral area 200NA, and sixth pads PD6 that are connected to the shield line EGL. The shield line EGL may be disposed adjacent to an outermost edge of the sensor layer 200. The shield line EGL may be referred to as an electrostatic shield line or a ground line, and the sixth pads PD6 may be referred to as ground pads. The shield line EGL may be grounded, or may receive a constant voltage. In addition, the display driver 100C is disposed at a side of the sensor layer 200 where the first pad PD1, the second pad PD2, the third pad PD3, the fourth pad PD4, the fifth pad PD5, and the sixth pad PD6 are disposed.

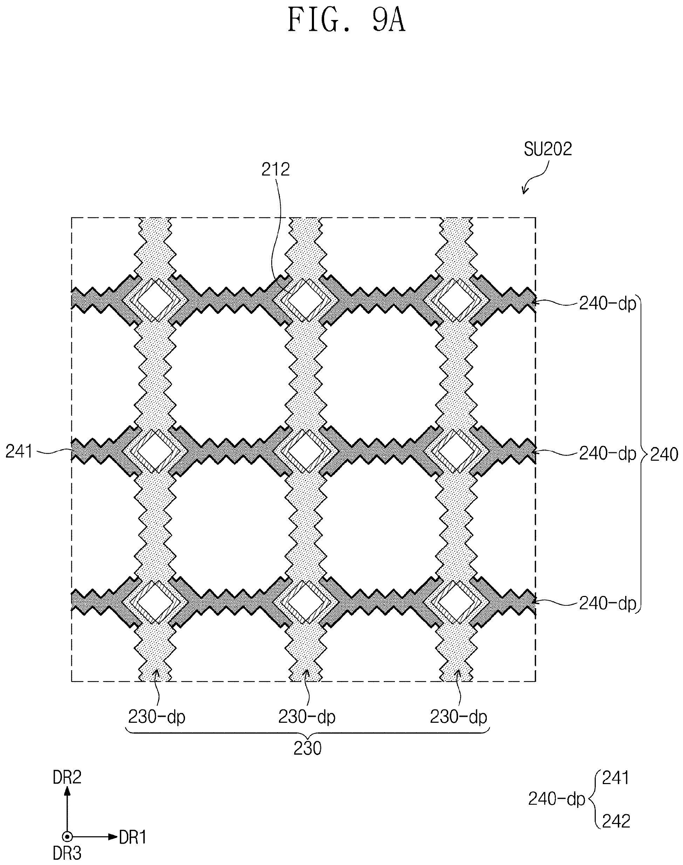

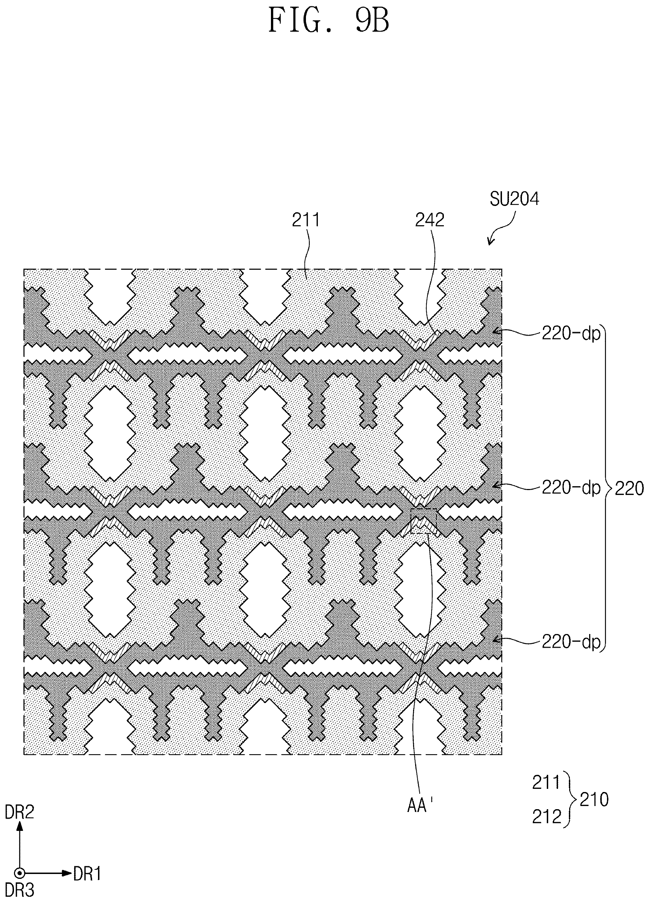

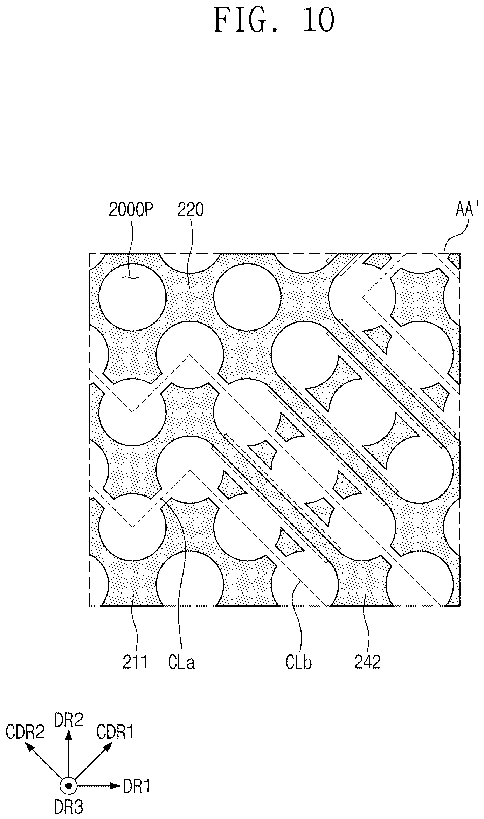

FIG. 9A is a plan view illustrating a first conductive layer SU202 of a sensing unit SU according to an embodiment of the present disclosure. FIG. 9B is a plan view illustrating a second conductive layer SU204 of the sensing unit SU according to an embodiment of the present disclosure. FIG. 10 is an enlarged plan view of the area AA' illustrated in FIG. 9B.

In FIGS. 9A and 9B, the shape of a mesh structure is not illustrated, but boundaries of the components are briefly illustrated as lines. In other words, the lines illustrated in FIGS. 9A and 9B may be understood as corresponding to the lines along which the mesh structure illustrated in FIG. 10 is removed, and lines CLa and CLb are illustrated by dotted lines in FIG. 10.

The shape and the mesh structure of the sensing unit SU illustrated in FIGS. 9A, 9B, and 10 are provided as examples, and the present disclosure is not limited thereto. The shape and the mesh structure of the sensing unit SU may be variously modified as needed or desired.

Referring to FIGS. 9A and 9B, the first electrode 210 may include a plurality of first patterns 211, and a plurality of first bridge patterns 212 that are electrically connected to the first patterns 211. The first patterns 211 that are arranged to be spaced apart from each other in the second direction DR2 may be electrically connected to each other by the first bridge patterns 212. The first patterns 211 may be included in the second conductive layer SU204, and the first bridge patterns 212 may be included in the first conductive layer SU202.

Two first patterns 211 that are adjacent to each other in the second direction DR2 in one first electrode 210 may be electrically connected to each other by six first bridge patterns 212. An increase in the number of the first bridge patterns 212 arranged along the first direction DR1 that crosses the second direction DR2 that is an extension direction of the first electrode 210 may correspond to an increase in the number of signal paths. Accordingly, as the number of the signal paths increases, the resistance of the first electrode 210 may decrease. As a result, the sensing sensitivity of the sensor layer 200 may be improved.

The second electrode 220 may include a plurality of first division electrodes 220-dp that are spaced apart from each other in the second direction DR2. Each of the first division electrodes 220-dp may extend in the first direction DR1, and the first division electrodes 220-dp may be spaced apart from each other in the second direction DR2. The first division electrodes 220-dp may be included in the second conductive layer SU204. Three first division electrodes 220-dp included in one second electrode 220 may be connected to one second trace line 220t (e.g., see FIG. 8).

The third electrode 230 may include a plurality of second division electrodes 230-dp that are spaced apart from each other in the first direction DR1. Each of the second division electrodes 230-dp may extend along the second direction DR2. The second division electrodes 230-dp may be spaced apart from each other along the first direction DR1. When viewed in the third direction DR3 (e.g., in a plan view), the second division electrodes 230-dp may at least partially overlap with the first patterns 211.

Referring to FIGS. 8 and 9A together, one second loop trace line 230rt2 is electrically connected to one first electrode group 230pc. One first electrode group 230pc may include two third electrodes 230. In this case, one second loop trace line 230rt2 may be electrically connected to six second division electrodes 230-dp. As such, a degree to which the number of pads increases in the sensor layer 200 may decrease.

The fourth electrode 240 may include a plurality of third division electrodes 240-dp that are spaced apart from each other in the second direction DR2. Each of the third division electrodes 240-dp may extend along the first direction DR1. Each of the third division electrodes 240-dp may include a plurality of second patterns 241, and a plurality of second bridge patterns 242 that are electrically connected to the second patterns 241. The second patterns 241 and the second bridge patterns 242 may be electrically connected to each other through contact holes defined in the intermediate insulating layer 203 (e.g., see FIG. 7A). Two adjacent second patterns 241 may be spaced apart from each other with one second division electrode 230-dp and two first bridge patterns 212 interposed therebetween.

In FIGS. 9A and 9B, it is illustrated, as an example, that three first division electrodes 220-dp, three second division electrodes 230-dp, and three third division electrodes 240-dp are included in one sensing unit SU, but the present disclosure is not particularly limited thereto. For example, each of the number of first division electrodes 220-dp, the number of second division electrodes 230-dp, and the number of third division electrodes 240-dp included in one sensing unit SU may be one, two, or four or more.

In an embodiment of the present disclosure, a first capacitor may be defined between the first electrode 210 and the third electrode 230, and a second capacitor may be defined between the second electrode 220 and the fourth electrode 240. A first capacitance of the first capacitor and a second capacitance of the second capacitor may be adjusted by an overlapping extent between the first electrode 210 and the third electrode 230 and an overlapping extent between the second electrode 220 and the fourth electrode 240, respectively.

As the first and second capacitances increase, an amount of an induced current that is transferred from the third electrode 230 to the first electrode 210 may increase, and an amount of an induced current that is transferred from the fourth electrode 240 to the second electrode 220 may increase. Accordingly, as the first and second capacitances increase, a pen sensing performance of the sensor layer 200 may be improved. Furthermore, the first and second capacitances may act as loads during a touch sensing. Accordingly, as the first and second capacitances decrease, a touch sensing performance may be improved.

In an embodiment of the present disclosure, the overlapping extent between the first electrode 210 and the third electrode 230 and the overlapping extent between the second electrode 220 and the fourth electrode 240 may be adjusted (e.g., may be easily adjusted). Accordingly, the sensor layer 200 having appropriate levels of capacitance in consideration of a touch sensitivity and a pen sensing sensitivity may be provided. As a result, an electronic device 1000 (e.g., see FIG. 2A) having improved pen sensing sensitivity and touch sensitivity may be provided.

In an embodiment of the present disclosure, an extent occupied by the components included in the first electrode 210 and the second electrode 220 in the second conductive layer SU204 in one sensing unit SU may be larger than an extent occupied by the components included in the third electrode 230 and the fourth electrode 240. A change in a capacitance due to the first input 2000 (e.g., see FIG. 6) may be greater as a distance becomes shorter. Accordingly, components for sensing the first input 2000 (e.g., see FIG. 6) may be arranged in a layer that is adjacent to (e.g., closer to) the surface of the electronic device 1000 (e.g., see FIG. 7A) to have a relatively greater extent. As a result, a touch performance may be improved.

Referring to FIGS. 9A, 9B, and 10, each of the first to fourth electrodes 210, 220, 230, and 240 may have a mesh structure. The mesh structure may be a structure in which a plurality of openings 2000P are defined. In FIG. 10, a circular shape in which each of the plurality of openings 2000P has a suitable curvature (e.g., a specific or predetermined curvature) is illustrated as an example, but the present disclosure is not particularly limited thereto. For example, each of the openings 2000P may be modified into have various suitable shapes other than the circular shape, such as a square shape, a polygonal shape, or an atypical shape.

In FIG. 10, portions of the first pattern 211, the second bridge pattern 242, and the second electrode 220 disposed in the second conductive layer SU204 are illustrated. The first pattern 211, the second bridge pattern 242, and the second electrode 220 may be electrically insulated from each other. For example, the first pattern 211, the second bridge pattern 242, and the second electrode 220 may be electrically insulated from each other by a first line CLa that extends along a first crossing direction CDR1 crossing the first direction DR1 and the second direction DR2, and a second line CLb that extends along a second crossing direction CDR2 crossing the first crossing direction CDR1. A portion and another portion of the conductive layer may be spaced apart from each other with the first line CLa and the second line CLb interposed therebetween.

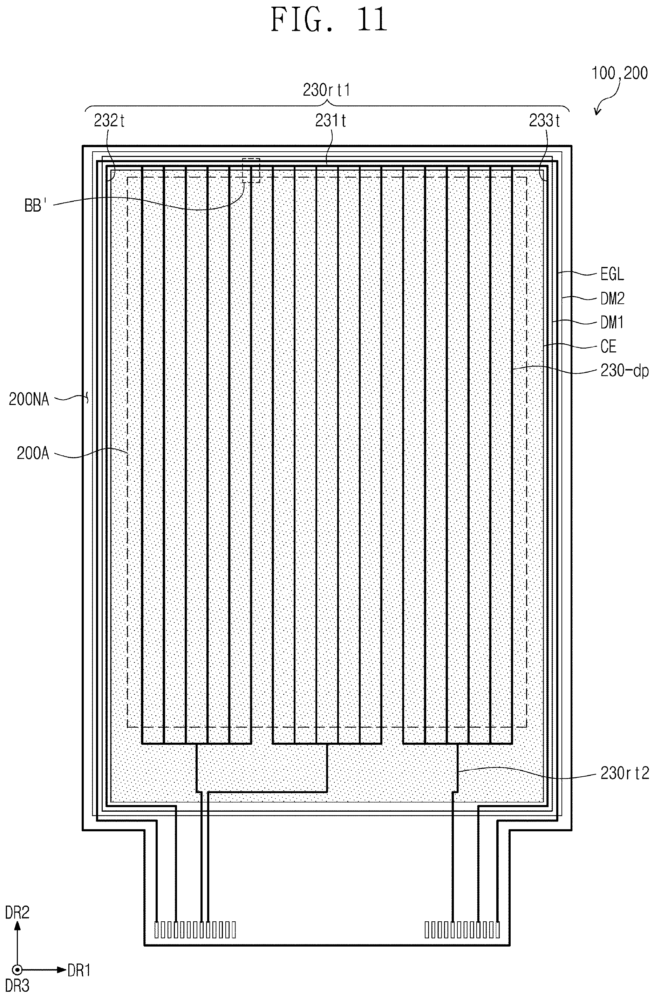

FIG. 11 is a plan view illustrating some components of a display layer 100 and some components of a sensor layer 200 according to an embodiment of the present disclosure.

Referring to FIG. 11, the second division electrodes 230-dp, the first loop trace line 230rt1, the second loop trace line 230rt2, and the shield line EGL of the sensor layer 200 are illustrated. The second division electrodes 230-dp are schematically illustrated as the form of lines. Furthermore, in FIG. 11, a second electrode CE (hereinafter referred to as a common electrode) of the display layer 100, a first dam part DM1, and a second dam part DM2 are illustrated.

In an embodiment of the present disclosure, each of the first dam part DM1 and the second dam part DM2 may have a closed loop shape that surrounds (e.g., around a periphery of) the common electrode CE. The first dam part DM1 and the second dam part DM2 may be disposed to overlap with the peripheral area 200NA. Each of the first dam part DM1 and the second dam part DM2 may have a suitable shape that surrounds (e.g., around a periphery of) the sensing area 200A. In an embodiment of the present disclosure, the second dam part DM2 may be omitted as needed or desired, or an additional dam part may be further disposed.

According to an embodiment of the present disclosure, a portion of the shield line EGL may be disposed in an area between the first dam part DM1 and the first line portion 231t, and another portion of the shield line EGL may be disposed between the first dam part DM1 and the second dam part DM2.

In an embodiment of the present disclosure, the shield line EGL may serve to shield a noise in an area between the first line portion 231t and the third electrodes 230. Accordingly, as the noise caused by the sensor layer 200 to the display layer 100 and the noise caused by the display layer 100 to the sensor layer 200 are shielded by the shield line EGL, both the quality of the image displayed on the display layer 100 and the performance of the sensor layer 200 may be improved.

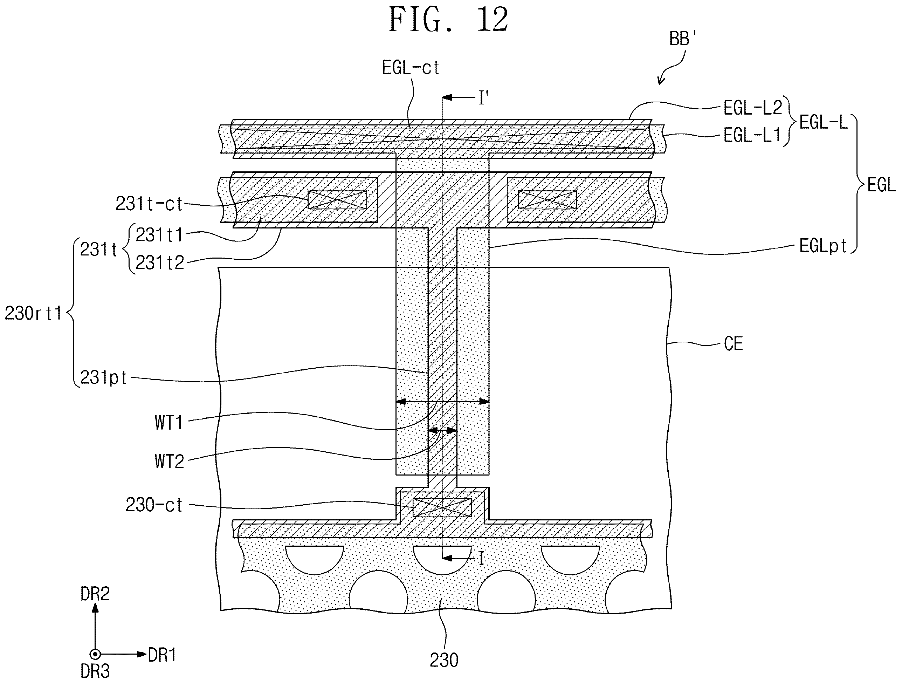

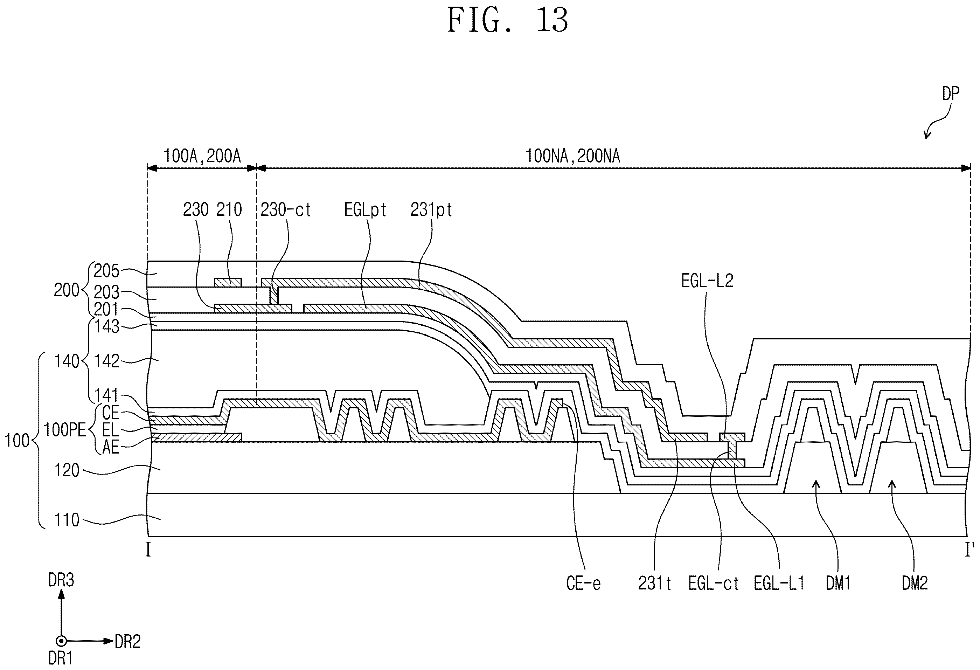

FIG. 12 is an enlarged plan view of the area BB' illustrated in FIG. 11. FIG. 13 is a cross-sectional view taken along the line I-I' illustrated in FIG. 12 according to an embodiment of the present disclosure.

Referring to FIGS. 11, 12, and 13, the first loop trace line 230rt1 may further include a plurality of protruding portions 231pt that protrude and extend from the first line portion 231t toward the third electrodes 230. In FIG. 12, one third electrode 230 and one protruding portion 231pt are illustrated by way of an example.

The shield line EGL may be disposed in the peripheral area 200NA, and may overlap with a plurality of protruding portions 231pt. For example, the shield line EGL may be disposed between the display layer 100 and the protruding portion 231pt. Accordingly, the shield line EGL may serve to shield a noise in an area that overlaps with the protruding portions 231pt. Accordingly, as the noise caused by the sensor layer 200 to the display layer 100 and the noise caused by the display layer 100 to the sensor layer 200 are shielded by the shield line EGL, both the quality of the image displayed on the display layer 100 and the performance of the sensor layer 200 may be improved.

In an embodiment of the present disclosure, the shield line EGL may include a shield line portion EGL-L that is spaced apart from the third electrode 230 and the sensing area 200A with the first line portion 231t interposed therebetween, and a shield protruding portion EGLpt that protrudes and extends from the shield line portion EGL-L and overlaps with the protruding portion 231pt.

The encapsulation layer 140 may include a first inorganic encapsulation layer 141 that covers the light emitting element 100PE, an organic encapsulation layer 142 that is disposed on the first inorganic encapsulation layer 141, and a second inorganic encapsulation layer 143 that is disposed on the organic encapsulation layer 142 to cover the organic encapsulation layer 142. Both the protruding portion 231pt and the shield protruding portion EGLpt may extend from an area that does not overlap with the organic encapsulation layer 142 toward an area that overlaps with the organic encapsulation layer 142.

A width WT1 of the shield protruding portion EGLpt in the first direction DR1 may be greater than a width WT2 of the protruding portion 231pt in the first direction DR1. Accordingly, the noise caused in a signal provided to the protruding portion 231pt and the noise generated in the signal provided to the protruding portion 231pt may be more easily shielded by the shield protruding portion EGLpt.

The shield line portion EGL-L may include a first shield line layer EGL-L1, and a second shield line layer EGL-L2 disposed on the first shield line layer EGL-L1 and connected to the first shield line layer EGL-L1 through a contact EGL-ct. The shield protruding portion EGLpt may protrude and extend from the first shield line layer EGL-L1.

According to an embodiment of the present disclosure, when viewed on a plane (e.g., in a plan view), the contact EGL-ct may have a line shape that extends along the first direction DR1. In other words, the contact EGL-ct may also extend in a line shape to correspond to an extension direction of the shield line portion EGL-L. In this case, the first shield line layer EGL-L1 and the second shield line layer EGL-L2 may be connected to each other through a line-kind of contact EGL-ct, rather than a dot-kind of contact, and thus, even when static electricity is generated in the shield line EGL and a local damage occurs in the contact EGL-ct, a resistance may not be changed significantly. Accordingly, even when the local damage caused by the static electricity is caused by the shape of the contact EGL-ct, a rapid increase in the resistance may be prevented.

The first line portion 231t may include a first line layer 231t1 that is disposed at (e.g., in or on) the same layer as that of the first shield line layer EGL-L1, and a second line layer 231t2 that is disposed at (e.g., in or on) the same layer as that of the second shield line layer EGL-L2 and connected to the first line layer 231t1 through a contact 231t-ct.

The protruding portion 231pt may protrude and extend from the second line layer 231t2. The protruding portion 231pt may cross an end CE-e of the common electrode CE to be electrically connected to the third electrode 230 through the contact 230-ct. The shield protruding portion EGLpt of the shield line EGL may be disposed between the end CE-e of the common electrode CE and the protruding portion 231pt.

According to an embodiment of the present disclosure, an intermediate insulating layer 203 may include an organic material. Compared to a case in which the intermediate insulating layer 203 includes an inorganic material, it may be easier to secure the thickness of the intermediate insulating layer 203 by a desired thickness (e.g., a specific or predetermined thickness) or more when the intermediate insulating layer 203 includes an organic material, and thus, an upper surface of the intermediate insulating layer 203 may be planarized easier. Furthermore, a dielectric constant of the organic layer may be relatively lower than that of the inorganic layer. Accordingly, a possibility of a short circuit occurring between the protruding portion 231pt and the shield protruding portion EGLpt may be eliminated or reduced. Furthermore, a capacitance of a parasitic capacitor formed between the protruding portion 231pt and the shield protruding portion EGLpt may be reduced.

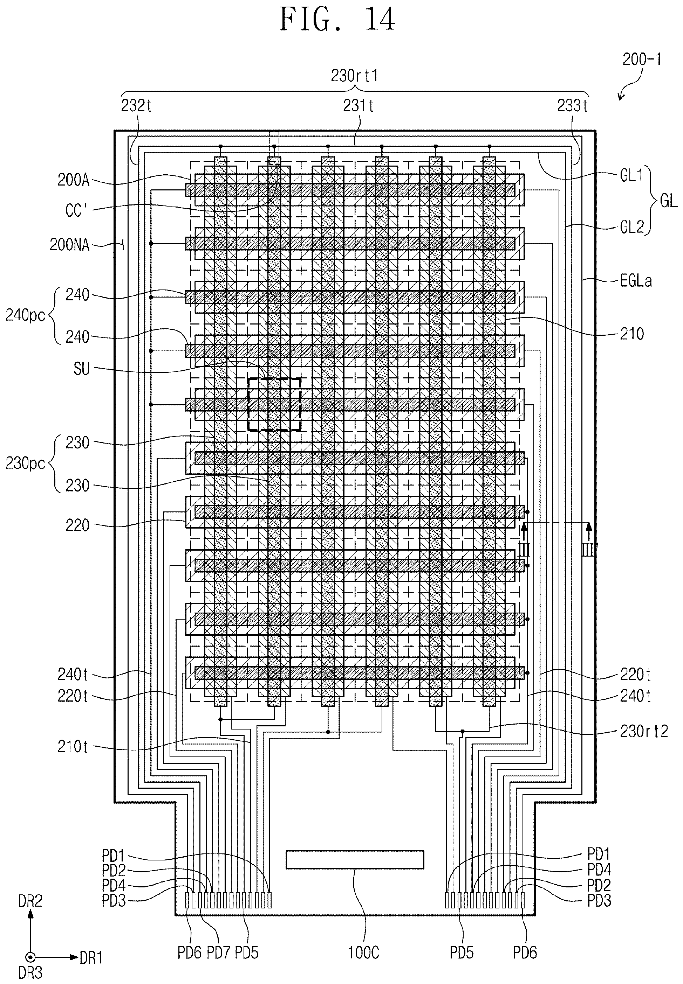

FIG. 14 is a plan view of a sensor layer 200-1 according to an embodiment of the present disclosure. In FIG. 14, the same reference numerals are assigned to the same or substantially the same components as those described above with reference to FIG. 8, and thus, redundant description thereof may not be repeated hereinafter.

Referring to FIG. 14, the sensor layer 200-1 may further include an electrostatic shield line EGLa disposed in a peripheral area 200NA, sixth pads PD6 connected to the electrostatic shield line EGLa, a shield line GL, and seventh pads PD7 connected to the shield line GL.

The electrostatic shield line EGLa may be disposed adjacent to an outermost edge of the sensor layer 200-1. The electrostatic shield line EGLa may be grounded, or may receive a constant voltage.

The shield line GL may include a first shield line portion GL1 that is disposed between the first line portion 231t and the third electrodes 230 or the sensing area 200A, and a second shield line portion GL2 that extends from an end of the first shield line portion GL1 along a direction parallel to or substantially parallel to the second direction DR2. The shield line GL may be referred to as a ground line. The shield line GL may be grounded, or may receive a constant voltage.

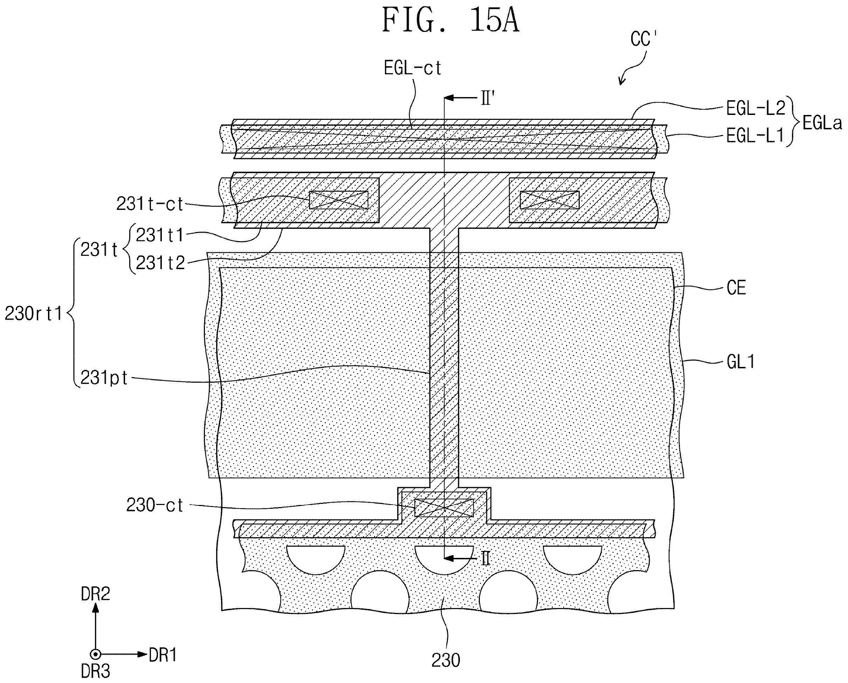

FIG. 15A is an enlarged plan view of the area CC' illustrated in FIG. 14.

Referring to FIGS. 14 and 15A, the electrostatic shield line EGLa includes the first shield line layer EGL-L1 and the second shield line layer EGL-L2. A first shield line portion GL1 of the shield line GL may be disposed between the first line portion 231t and the third electrodes 230. In other words, the first shield line portion GL1 may be disposed between the first line portion 231t and the sensing area 200A. The protruding portion 231pt may overlap with the first shield line portion GL1. Accordingly, the first shield line portion GL1 may serve to shield a noise in an area that overlaps with the protruding portions 231pt.

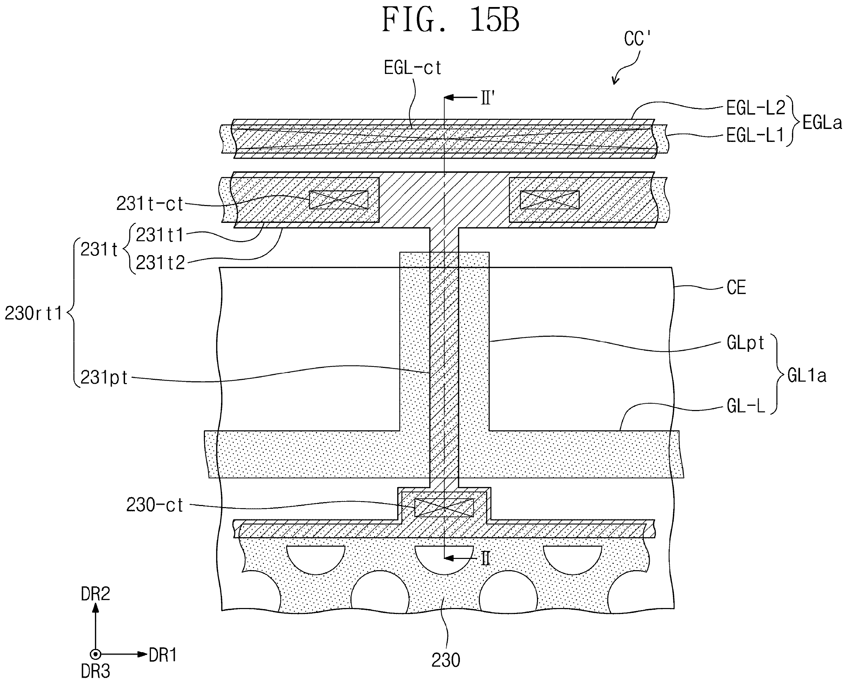

FIG. 15B is an enlarged plan view of the area CC' illustrated in FIG. 14.

Referring to FIGS. 14 and 15B, a first shield line portion GL1a of the shield line GL may be disposed between the first line portion 231t and the third electrodes 230 or the sensing area 200A. The first shield line portion GL1a may include a line portion GL-L that extends along the first direction DR1, and a shield protruding portion GLpt that protrudes from the line portion GL-L in the second direction DR2. The shield protruding portion GLpt may overlap with the protruding portion 231pt. Accordingly, the first shield line portion GL1a may serve to shield a noise in an area that overlaps with the protruding portions 231pt.

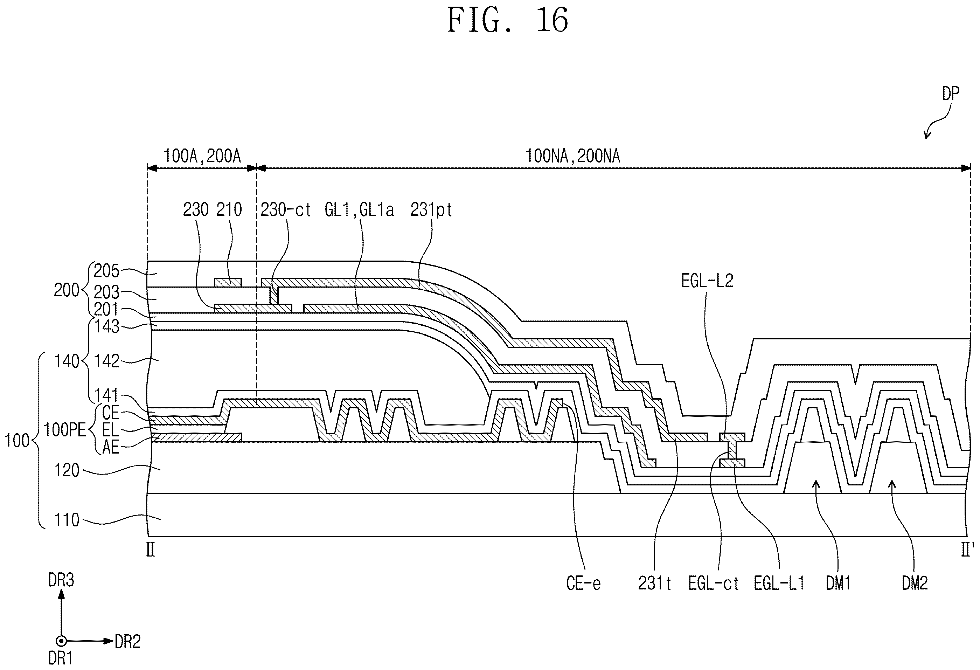

FIG. 16 is a cross-sectional view taken along the line II-II' illustrated in FIG. 15A or the line II-II' illustrated in FIG. 15B according to an embodiment of the present disclosure.

Referring to FIG. 16, the first shield line portion GL1 or GL1a may be disposed between the display layer 100 and the protruding portion 231pt. Accordingly, as the noise caused by the sensor layer 200 to the display layer 100 and the noise caused by the display layer 100 to the sensor layer 200 are shielded by the first shield line portion GL1 or GL1a, both the quality of the image displayed on the display layer 100 and the performance of the sensor layer 200 may be improved.

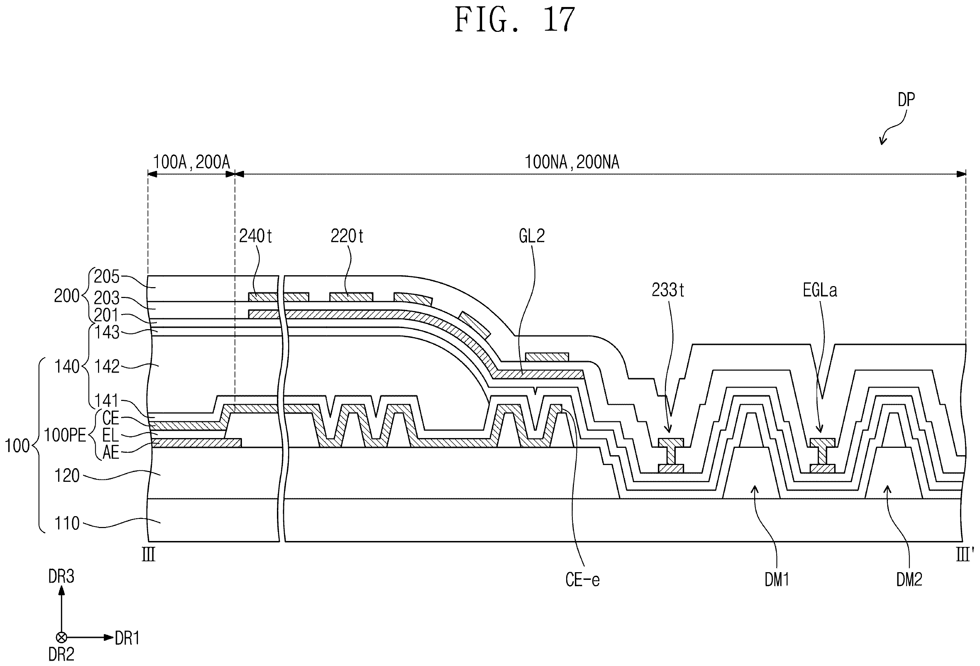

FIG. 17 is a cross-sectional view taken along the line III-III' illustrated in FIG. 14 according to an embodiment of the present disclosure.

Referring to FIGS. 14 and 17, the second shield line portion GL2 may have a shape that extends toward the sensing area 200A. In this case, at least some of the second trace lines 220t may overlap with the second shield line portion GL2.

According to an embodiment of the present disclosure, because a convexo-concave pattern disposed in the non-display area 100NA may additionally be covered by the second shield line portion GL2 and a noise may be shielded by the second shield line portion GL2, an area in which the second trace lines 220t may be disposed may be further expanded. For example, a portion of the second trace lines 220t may also be disposed in an area that overlaps with the convexo-concave pattern. For example, at least some of the second trace lines 220t may be disposed in an area that does not overlap with the organic encapsulation layer 142.

In other words, according to an embodiment of the present disclosure, an extent in which the second trace lines 220t may be disposed may be widened. Accordingly, a resistance of each of the second trace lines 220t may be decreased by increasing the widths of the second trace lines 220t, even when the second trace lines 220t have a single layer structure rather than a multilayered structure by the second shield line portion GL2.

In an embodiment of the present disclosure, the third line portion 233t of the first loop trace line 230rt1 (e.g., see FIG. 14) may not overlap with the second shield line portion GL2. Furthermore, the third line portion 233t may not overlap with the common electrode CE. As the positions of the second line portion 232t (e.g., see FIG. 14) and the third line portion 233t are designed to be located in an area that does not overlap with the common electrode CE, the resistances of not only the second line portion 232t and the third line portion 233t, but also the resistance of the second trace lines 220t or the auxiliary trace line 240t, may be further lowered. As the resistance of each trace line decreases, a distortion or a noise may decrease when a signal is transmitted through the trace line.

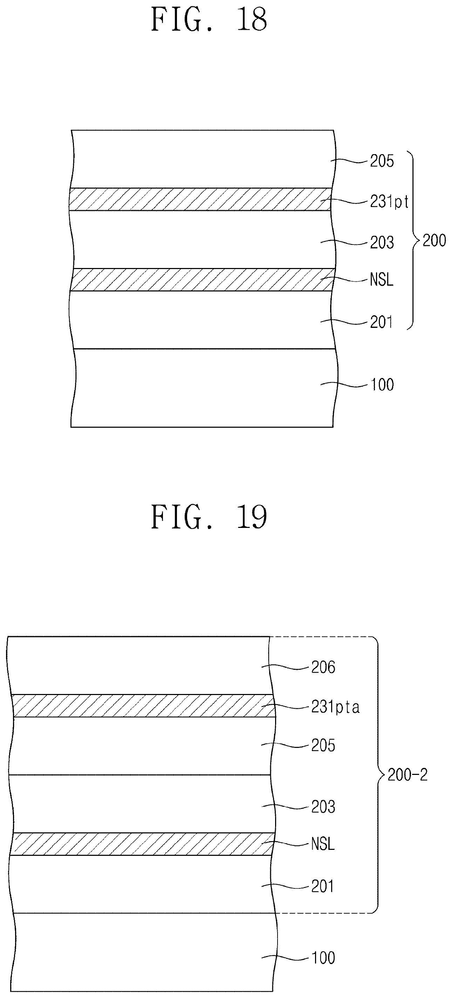

FIG. 18 is a schematic cross-sectional view of a display layer 100 and a sensor layer 200 according to an embodiment of the present disclosure.

Referring to FIG. 18, the display layer 100, the base layer 201, a shield layer NSL, the intermediate insulating layer 203, the protruding portion 231pt, and the cover insulating layer 205 are illustrated by way of an example.

In an embodiment of the present disclosure, the shield layer NSL may be included in the first conductive layer 202 (e.g., see FIG. 7A), and the protruding portion 231pt may be included in the second conductive layer 204. The shield layer NSL may be disposed between the display layer 100 and the protruding portion 231pt.

The intermediate insulating layer 203 may include an organic material. In this case, because it may be easier to secure the thickness of the intermediate insulating layer 203 by a desired thickness or more, an upper surface of the intermediate insulating layer 203 may be planarized more easily. Furthermore, a dielectric constant of the organic layer may be relatively lower than that of the inorganic layer. Accordingly, a possibility of a short circuit occurring between the protruding portion 231pt and the shield layer NSL may be eliminated or reduced. Furthermore, a capacitance of a parasitic capacitor formed in the protruding portion 231pt may be reduced.

FIG. 19 is a schematic cross-sectional view of a display layer 100 and a sensor layer 200-2 according to an embodiment of the present disclosure.

Referring to FIG. 19, the display layer 100 and the sensor layer 200-2 are illustrated. The protruding portion 231pta of the sensor layer 200-2 may be disposed on the cover insulating layer 205. Furthermore, the sensor layer 200-2 may further include an additional cover insulating layer 206 that is disposed on the cover insulating layer 205 to cover the protruding portion 231pta.

According to an embodiment of the present disclosure, an interval between the shield layer NSL and the protruding portion 231pta may be greater than an interval between the shield layer NSL and the protruding portion 231pt illustrated in FIG. 18. Accordingly, capacitances of parasitic capacitors formed in the protruding portion 231pta and the shield layer NSL may be further reduced.

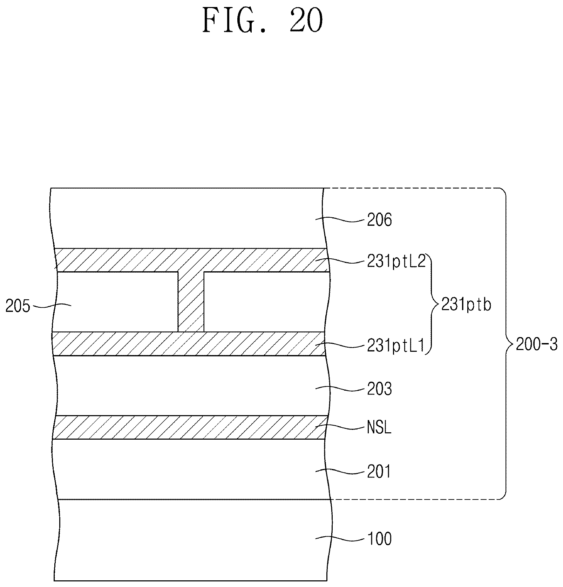

FIG. 20 is a schematic cross-sectional view of a display layer 100 and a sensor layer 200-3 according to an embodiment of the present disclosure.

Referring to FIG. 20, the display layer 100 and the sensor layer 200-3 are illustrated. The protruding portion 231ptb may include a first layer 231ptL1, and a second layer 231ptL2 electrically connected to the first layer 231ptL1 and disposed on the first layer 231ptL1. Furthermore, the sensor layer 200-3 may further include an additional cover insulating layer 206 that is disposed on the cover insulating layer 205 to cover the second layer 231ptL2 of the protruding portion 231ptb.

According to an embodiment of the present disclosure, the protruding portion 231ptb may have a multilayered structure. Accordingly, the resistance may become relatively lower compared to the case in which the protruding portion 231ptb is provided as a single layer.

Referring to FIGS. 18, 19, and 20, the shield layer NSL may be the shield line EGL illustrated in FIG. 8 or the shield line GL illustrated in FIG. 14. The shield layer NSL may be disposed between the display layer 100 and the protruding portions 231pt, 231pta, or 231ptb. The shield layer NSL may be grounded, or may receive a constant voltage. Accordingly, as the noise caused by the sensor layer 200, 200-2, or 200-3 to the display layer 100 and the noise caused by the display layer 100 to the sensor layer 200, 200-2, or 200-3 are shielded by the shield layer NSL, both the quality of the image displayed on the display layer 100 and the performance of the sensor layer 200, 200-2, or 200-3 may be improved.

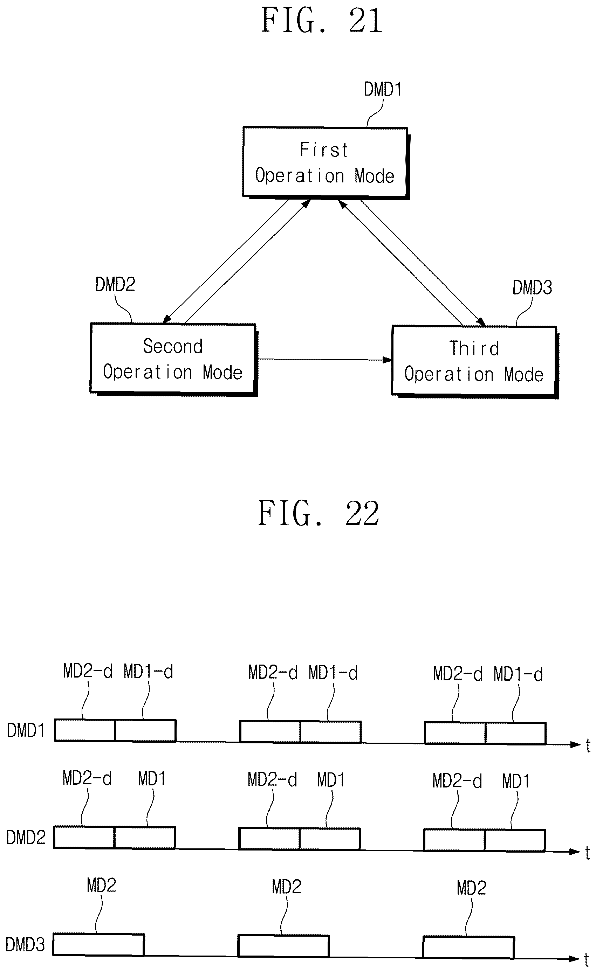

FIG. 21 is a block diagram illustrating an operation of the sensor driver 200C according to an embodiment of the present disclosure.

Referring to FIGS. 6 and 21, the sensor driver 200C may be selectively operated in any one of a first operation mode DMD1, a second operation mode DMD2, and a third operation mode DMD3.

The first operation mode DMD1 may be referred to as a touch and pen standby mode, the second operation mode DMD2 may be referred to as a touch activation and pen standby mode, and the third operation mode DMD3 may be referred to as a pen activation mode. The first operation mode DMD1 may be a mode for waiting for the first input 2000 and the second input 3000. The second operation mode DMD2 may be a mode for sensing the first input 2000 and waiting for the second input 3000. The third operation mode DMD3 may be a mode for sensing the second input 3000.

In an embodiment of the present disclosure, the sensor driver 200C may be driven first in the first operation mode DMD1. When the first input 2000 is sensed in the first operation mode DMD1, the operation mode of the sensor driver 200C may be switched (or changed) to the second operation mode DMD2. As another example, when the second input 3000 is sensed in the first operation mode DMD1, the operation mode of the sensor driver 200C may be switched (or changed) to the third operation mode DMD3.

In an embodiment of the present disclosure, when the second input 3000 is sensed in the second operation mode DMD2, the operation mode of the sensor driver 200C may be switched to the third operation mode DMD3. When the first input 2000 is terminated (or not sensed) in the second operation mode DMD2, the operation mode of the sensor driver 200C may be switched to the first operation mode DMD1. When the second input 3000 is terminated (or not sensed) in the third operation mode DMD3, the operation mode of the sensor driver 200C may be switched to the first operation mode DMD1.

FIG. 22 illustrates an operation of the sensor driver 200C according to an embodiment of the present disclosure.

Referring to FIGS. 6, 21, and 22, operations in the first to third operation modes DMD1, DMD2, and DMD3 are illustrated in order of time (t), by way of an example.

In the first operation mode DMD1, the sensor driver 200C may be repeatedly operated in a second mode MD2-d and a first mode MD1-d. During the second mode MD2-d, the sensor layer 200 may perform scan driving for detecting the second input 3000. During the first mode MD1-d, the sensor layer 200 may perform scan driving to detect the first input 2000. FIG. 22 illustrates that the sensor driver 200C is operated in the first mode MD1-d continuously after the second mode MD2-d, but the order is not limited thereto.

In the second operation mode DMD2, the sensor driver 200C may be repeatedly operated in a second mode MD2-d and a first mode MD1. During the second mode MD2-d, the sensor layer 200 may perform scan driving to detect the second input 3000. During the first mode MD1, the sensor layer 200 may perform scan driving to detect coordinates corresponding to the first input 2000.

In the third operation mode DMD3, the sensor driver 200C may be operated in the second mode MD2. During the second mode MD2, the sensor layer 200 may perform scan driving to detect coordinates corresponding to the second input 3000. In the third operation mode DMD3, the sensor driver 200C may not be operated in the first mode MD1-d or MD1 until the second input 3000 is terminated (or not sensed).

Referring to FIG. 8 together, in the first mode MD1-d and the first mode MD1, all of the third electrodes 230 and the fourth electrodes 240 may be grounded, or a constant voltage may be applied thereto. As another example, in the first mode MD1-d and the first mode MD1, both the third electrodes 230 and the fourth electrodes 240 may be floated (or electrically floated). As another example, in the first mode MD1-d and the first mode MD1, a signal of the same phase as that of the transmission signal provided to the first electrodes 210 may be applied to the third electrodes 230 and the fourth electrodes 240. In this case, a touch noise may be prevented from being introduced through the third electrodes 230 and the fourth electrodes 240.

In the second mode MD2-d and the second mode MD2, all of ends of the third electrodes 230 and the fourth electrodes 240 may be floated. Moreover, in the second mode MD2-d and the second mode MD2, the opposite ends of the third electrodes 230 and the fourth electrodes 240 may be grounded or floated. Accordingly, a compensation for the sensing signal may be maximized through a coupling between the first electrodes 210 and the third electrodes 230 and a coupling between the second electrodes 220 and the fourth electrodes 240.

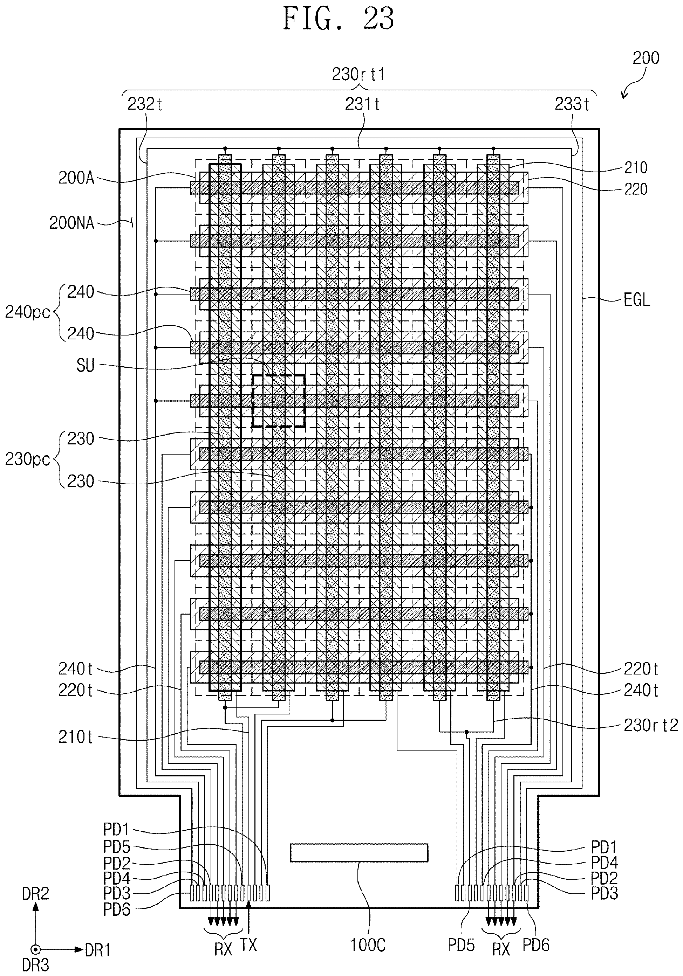

FIG. 23 is a schematic view illustrating a first mode according to an embodiment of the present disclosure.

Referring to FIGS. 6, 22, and 23, the first mode MD1-d of the first operation mode DMD1 and the first mode MD1 of the second operation mode DMD2 may include a mutual capacitance detection mode. FIG. 23 illustrates a mutual capacitance detection mode in the first mode MD1-d of the first operation mode DMD1 and the first mode MD1 of the second operation mode DMD2.

In the mutual capacitance detection mode, the sensor driver 200C may sequentially provide a transmission signal TX to the first electrodes 210, and may detect coordinates for the first input 2000 by using a reception signal RX detected through the second electrodes 220. For example, the sensor driver 200C may calculate input coordinates by sensing changes in a mutual capacitance between the first electrodes 210 and the second electrodes 220. As another example, the sensor driver 200C may sequentially provide a transmission signal TX to the second electrodes 220, and may detect coordinates for the first input 2000 by using a reception signal RX detected through the first electrodes 210.

FIG. 23 illustrates that the transmission signal TX is provided to one first electrode 210, and the reception signal RX is output from the second electrodes 220. For convenience of illustration of a signal, FIG. 23 illustrates only one first electrode 210 to which the transmission signal TX is provided in bold. The sensor driver 200C may detect input coordinates of the first input 2000 by sensing a change in a capacitance between the first electrode 210 and each of the second electrodes 220.

In another embodiment of the present disclosure, at least one of the first mode MD1-d of the first operation mode DMD1 and/or the first mode MD1 of the second operation mode DMD2 may further include a self-capacitance detection mode. In the self-capacitance detection mode, the sensor driver 200C may output driving signals to the first electrodes 210 and the second electrodes 220, and may calculate input coordinates by sensing changes in a capacitance of each of the first electrodes 210 and the second electrodes 220.

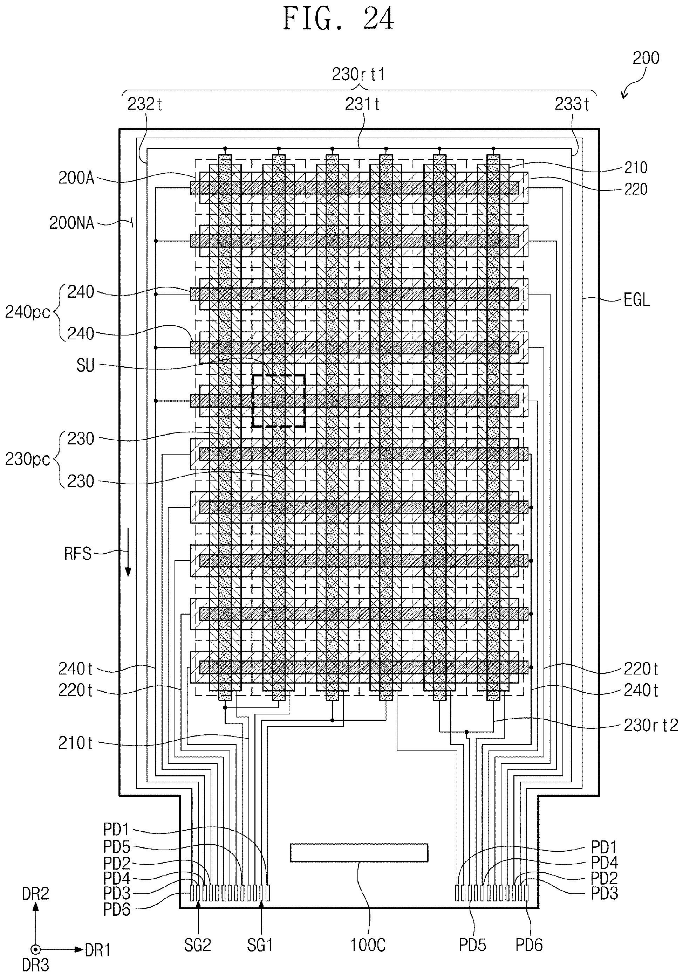

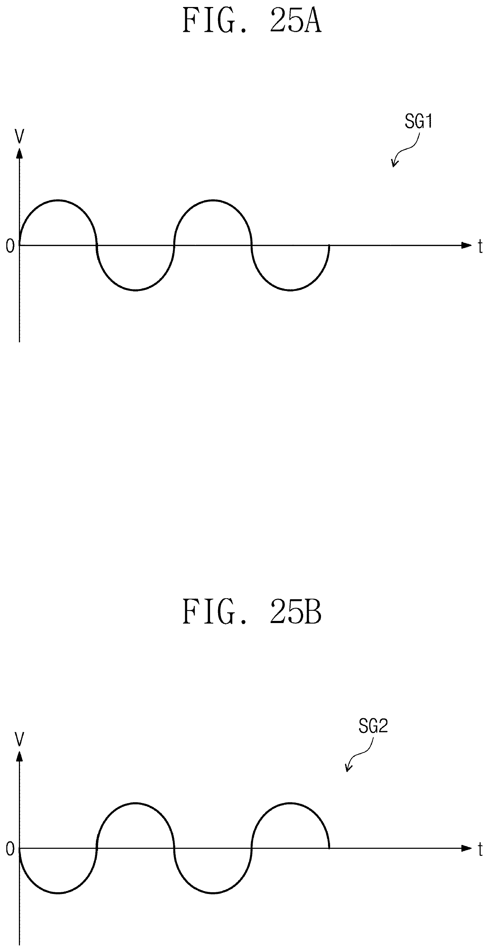

FIG. 24 is a schematic view illustrating a second mode according to an embodiment of the present disclosure. For example, FIG. 24 may illustrate a charging driving mode according to an embodiment of the present disclosure. FIG. 25A is a graph illustrating a waveform of a first signal according to an embodiment of the present disclosure. FIG. 25B is a graph illustrating a waveform of a second signal according to an embodiment of the present disclosure.

Referring to FIGS. 24, 25A, and 25B, the second mode MD2 may include a charging driving mode. The charging driving mode may include a search charging driving mode and a tracking charging driving mode.

The search charging driving mode may be a driving mode before a location of the pen is sensed. Accordingly, a first signal SG1 or a second signal SG2 may be provided to all channels included in the sensor layer 200. In other words, an entire area of the sensor layer 200 may be scanned in the search charging driving mode. When the pen PN is sensed in the search charging driving mode, the sensor layer 200 may be driven for tracking charging. For example, in the tracking charging driving mode, the sensor driver 200C may sequentially output the first signal SG1 and the second signal SG2 not to the entire sensor layer 200, but to an area that overlaps with a point at which the pen PN is sensed.

In the charging driving mode, the sensor driver 200C may apply the first signal SG1 to one of the third pads PD3 and/or the fifth pads PD5, and may apply the second signal SG2 to another pad. The second signal SG2 may be a reverse signal of the first signal SG1. For example, the first signal SG1 may be a sinusoidal wave signal.

Because the first signal SG1 and the second signal SG2 are applied to at least two pads, a current RFS may have a current path through one pad to another pad. Furthermore, because the first signal SG1 and the second signal SG2 may be sinusoidal wave signals having a reverse-phase relationship to each other, the direction of the current RFS may be changed periodically. In an embodiment of the present disclosure, the first signal SG1 and the second signal SG2 may be square wave signals having a reverse-phase relationship to each other.

When the first signal SG1 and the second signal SG2 have a reverse-phase relationship, a noise caused by the first signal SG1 in the display layer 100 (e.g., see FIG. 5) may be canceled out with a noise caused by the second signal SG2. Accordingly, a flicker may not occur in the display layer 100, and the display quality of the display layer 100 may be improved.

In an embodiment of the present disclosure, the first signal SG1 may be a sinusoidal wave signal. However, the present disclosure is not limited thereto, and the first signal SG1 may be a square wave signal. Further, the second signal SG2 may have a suitable constant voltage (e.g., a predetermined constant voltage). For example, the second signal SG2 may be a ground voltage. In other words, a pad to which the second signal SG2 is applied may be grounded. In this case, the current RFS may flow from one pad to another pad. Also, because the first signal SG1 may be a sinusoidal wave signal or square wave signal, even when the other pad is grounded, a direction of the current RFS may be changed periodically.

Referring to FIG. 24, the second signal SG2 is provided through one third pad PD3 that is connected to one first loop trace line 230rt1, and the first signal SG1 is provided through one fifth pad PD5 that is connected to the third electrode 230. The current RFS may flow through a current path that is defined by the fifth pad PD5, the second loop trace line 230rt2 connected to the fifth pad PD5, the third electrode 230, a portion of the first loop trace line 230rt1, which is connected to the third pad PD3, and the third pad PD3. The current path may have the form of a coil. Accordingly, in the charging driving mode of the second mode, the resonant circuit of the pen PN may be charged by the current path.

According to some embodiments of the present disclosure, a current path of a loop coil pattern may be implemented by the components included in the sensor layer 200. Accordingly, the electronic device 1000 (e.g., see FIG. 2A) may charge the pen PN by using the sensor layer 200. As such, because there may be no need to add a separate configuration (e.g., a digitizer or the like) having a coil for charging the pen PN, the thickness, the weight, and the flexibility of the electronic device 1000 may not be increased due to the addition of the separate configuration.

In the charging driving mode, the first electrodes 210, the second electrodes 220, and the fourth electrodes 240 may be grounded, or may be electrically floated. In more detail, the first electrodes 210, the second electrodes 220, and the fourth electrodes 240 may be floated. In this case, the current RFS may not flow to the first electrodes 210, the second electrodes 220, and the fourth electrodes 240.

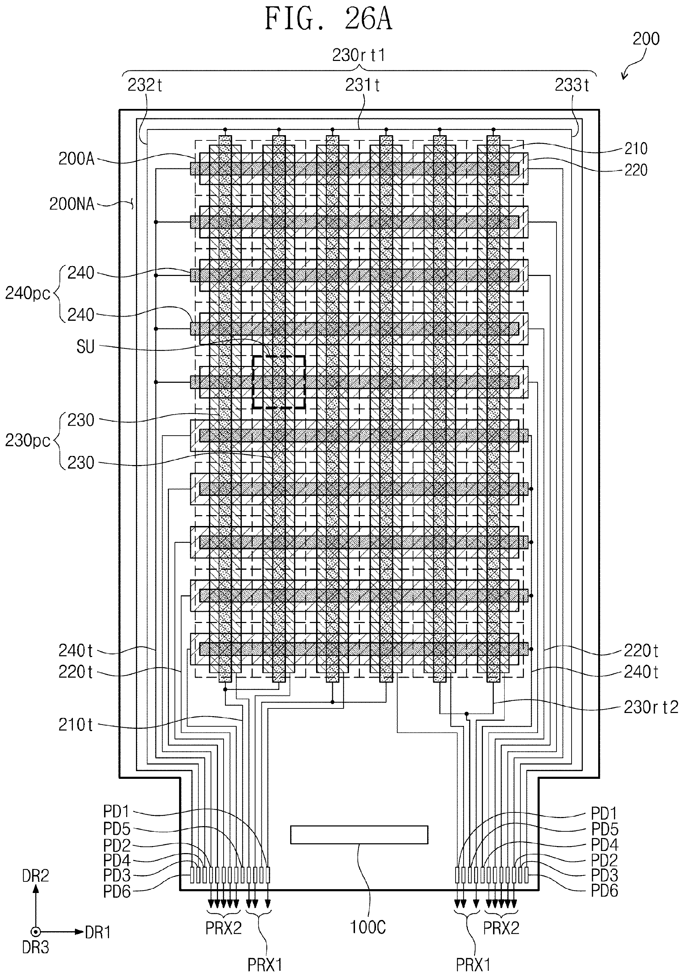

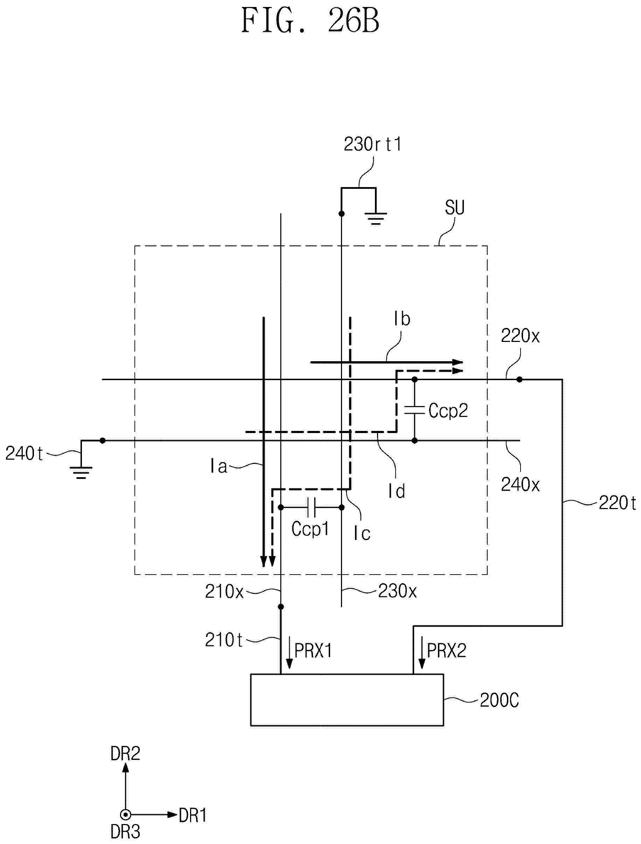

FIG. 26A is a schematic view illustrating a second mode according to an embodiment of the present disclosure. FIG. 26B is a schematic view illustrating a second mode based on one sensing unit according to an embodiment of the present disclosure.

Referring to FIGS. 26A and 26B, a second mode may include a charging driving mode and a pen sensing driving mode. FIGS. 26A and 26B illustrate the pen sensing driving mode.

Referring to FIG. 26A, in the pen sensing driving mode, first reception signals PRX1 may be output from the first electrodes 210, and second reception signals PRX2 may be output from the second electrodes 220. One sensing unit SU, through which first to fourth induced currents (la, Ib, Ic, and Id) generated by a pen PN flow, is illustrated in FIG. 26B.

Referring to FIGS. 26A and 26B, in an embodiment of the present disclosure, routing directions of one electrode and another electrode of the sensor layer 200, which overlap with each other, may be different from each other. For example, the routing direction of the first electrode 210x and the routing direction of the third electrode 230x may be different from each other. Furthermore, the routing direction of the second electrode 220x and the routing direction of the fourth electrode 240x may be different from each other. For example, in FIG. 26B, the first electrode 210x and the first trace line 210t may be connected to each other at a lower portion of the sensing unit SU, and the third electrode 230x and the first loop trace line 230rt1 may be connected to each other at an upper portion of the sensing unit SU. The second electrode 220x and the second trace line 220t may be connected on the right side of the sensing unit SU, and the fourth electrode 240x and the auxiliary trace line 240t may be connected on the left side of the sensing unit SU.

An RLC resonant circuit of the pen PN may emit a magnetic field at a resonant frequency while discharging charged charges. Due to the magnetic field provided by the pen PN, a first induced current la may be generated in the first electrode 210x, and a second induced current Ib may be generated in the second electrode 220x. Furthermore, a third induced current Ic may be generated in the third electrode 230x, and a fourth induced current Id may be generated in the fourth electrode 240x.

A first coupling capacitor Ccp1 may be formed between the third electrode 230x and the first electrode 210x, and a second coupling capacitor Ccp2 may be formed between the fourth electrode 240x and the second electrode 220x. The third induced current Ic may be delivered to the first electrode 210x through the first coupling capacitor Ccp1, and the fourth induced current Id may be delivered to the second electrode 220x through the second coupling capacitor Ccp2.

The sensor driver 200C may receive a first reception signal PRX1 based on the first induced current la and the third induced current Ic from the first electrode 210x, and may receive a second reception signal PRX2 based on the second induced current Ib and the fourth induced current Id from the second electrode 220x. The sensor driver 200C may detect input coordinates of the pen PN based on the first reception signal PRX1 and the second reception signal PRX2.

The sensor driver 200C may receive the first reception signal PRX1 from the first electrode 210x, and may receive the second reception signal PRX2 from the second electrode 220x. In this case, all ends of the third electrode 230x and the fourth electrode 240x may be floated. Accordingly, the sensing signal may be maximally compensated for through the coupling between the first electrode 210x and the third electrode 230x and the coupling between the second electrodes 220x and the fourth electrode 240x.

The opposite ends of the third electrode 230x and the fourth electrode 240x may be grounded or floated. Accordingly, the third induced current Ic and the fourth induced current Id may be sufficiently respectively delivered to the first electrode 210x and the second electrode 220x through the coupling between the first electrode 210x and the third electrode 230x and through the coupling between the second electrode 220x and the fourth electrodes 240x.

According to some embodiments described above, the shield line may overlap with the plurality of protruding portions of the loop trace line. For example, the shield line may be disposed between the display layer and the protruding portion. The shield line may serve to shield a noise in an area that overlaps with the protruding portions. Accordingly, as the noise caused by the sensor layer to the display layer and the noise caused by the display layer to the sensor layer are shielded by the shield line, both the quality of the image displayed on the display layer and the performance of the sensor layer may be improved.

The foregoing is illustrative of some embodiments of the present disclosure, and is not to be construed as limiting thereof. Although some embodiments have been described, those skilled in the art will readily appreciate that various modifications are possible in the embodiments without departing from the scope of the present disclosure. It will be understood that descriptions of features or aspects within each embodiment should typically be considered as available for other similar features or aspects in other embodiments, unless otherwise described. Thus, as would be apparent to one of ordinary skill in the art, features, characteristics, and/or elements described in connection with a particular embodiment may be used singly or in combination with features, characteristics, and/or elements described in connection with other embodiments unless otherwise specifically indicated. Therefore, it is to be understood that the foregoing is illustrative of various example embodiments and is not to be construed as limited to the specific embodiments disclosed herein, and that various modifications to the disclosed embodiments, as well as other example embodiments, are intended to be included within the scope of the present disclosure as defined in the appended claims, and their equivalents.

## Claims

1. An electronic device (1000) comprising:
a display layer (100) configured to display an image; and
a sensor layer (200) on the display layer (100), and configured to sense an external input,
wherein the sensor layer (200) comprises:
a plurality of first electrodes (210) along a first direction (DR1);
a plurality of second electrodes (220) along a second direction (DR2) crossing the first direction (DR1);
a plurality of third electrodes (230) along the first direction (DR1);
a loop trace line (230rt1) comprising:
a first line portion (231t) extending in the first direction (DR1); and
a protruding portion (231pt) protruding and extending from the first line portion (231t) toward the plurality of third electrodes (230), and electrically connected to the plurality of third electrodes (230); and
a shield line (EGL) between the protruding portion (231pt) and the display layer (100).

2. The electronic device (1000) of claim 1, wherein the shield line (EGL) comprises:
a shield line portion (EGL-L) spaced from the plurality of third electrodes (230); and
a shield protruding portion (EGLpt) protruding and extending from the shield line portion (EGL-L), and overlapping with the protruding portion (231pt), and
wherein the first line portion (231t) is located between the shield line portion (EGL-L) and the plurality of third electrodes (230).

3. The electronic device (1000) of claim 2, wherein a width (WT1) of the shield protruding portion (EGLpt) in the first direction (DR1) is greater than a width (WT2) of the protruding portion (231pt) in the first direction (DR1).

4. The electronic device (1000) of claim 2 or claim 3, wherein the shield line portion (EGL-L) comprises:
a first shield line layer (EGL-L1); and
a second shield line layer (EGL-L2) on the first shield line layer (EGL-L1), and connected to the first shield line layer (EGL-L1) through a contact (EGL-ct), and
wherein the contact (EGL-ct) has a line shape extending along the first direction (DR1).

5. The electronic device (1000) of claim 4, wherein the shield protruding portion (EGLpt) protrudes and extends from the first shield line layer (EGL-L1).

6. The electronic device (1000) of claim 4 or claim 5, wherein the first line portion (231t) comprises:
a first line layer (231t1) at a same layer as that of the first shield line layer (EGL-L1); and
a second line layer (231t2) at a same layer as that of the second shield line layer (EGL-L2), and connected to the first line layer (EGL-L1) through a contact (231t-ct), and
wherein the protruding portion (231pt) protrudes and extends from the second line layer (231t2).

7. The electronic device (1000) of any preceding claim, wherein the shield line (EGL) is located between the first line portion (231t) and the plurality of third electrodes (230).

8. The electronic device (1000) of any preceding claim, wherein the sensor layer (200) further comprises:
a plurality of first trace lines (210t) electrically connected to the plurality of first electrodes (210) in a one-to-one correspondence; and
a plurality of second trace lines (220t) electrically connected to the plurality of second electrodes (220) in a one-to-one correspondence,
wherein the loop trace line (230rt1) further comprises:
a second line portion (232t) extending from an end of the first line portion (231t) in the second direction (DR2); and
a third line portion (233t) extending from an opposite end of the first line portion (231t) in the second direction (DR2), and
wherein some of the plurality of second trace lines (220t) are located between the second line portion (232t) and the plurality of first electrodes (210), and others of the plurality of second trace lines (220t) are located between the third line portion (233t) and the plurality of first electrodes (210).

9. The electronic device (1000) of claim 8, wherein the shield line (EGL) comprises:
a first shield line portion (GL1) extending in the first direction (DR1), and overlapping with the protruding portion (231pt); and
a second shield line portion (GL2) extending from an end of the first shield line (GL1) portion in the second direction (DR2), and
wherein at least some of the plurality of second trace lines (220t) overlap with the second shield line portion (GL2).

10. The electronic device (1000) of claim 9, wherein the third line portion (233t) does not overlap with the second shield line portion (GL2).

11. The electronic device (1000) of any preceding claim, wherein the display layer (100) comprises:
a light emitting element (100PE) comprising a pixel electrode (AE), an emission layer (EL) on the pixel electrode (AE), and a common electrode (CE) on the emission layer (EL), and
wherein the shield line (EGL) is located between an end of the common electrode (CE) and the protruding portion (231 pt).

12. The electronic device (1000) of any preceding claim, further comprising:
a ground pad (PD6) connected to the shield line (EGL).

13. The electronic device (1000) of any preceding claim, wherein the shield line (EGL) is configured to receive a constant voltage.
